# EUROPEAN PATENT SPECIFICATION

(11) **EP 3 260 953 B1**
(45) Date of publication and mention of the grant of the patent: **20.03.2024**
(21) Application number: 17176813.8
(22) Date of filing: 20.06.2017
(51) Int. Cl.: H10N 30/20, G06F 3/01

(54) **LOCALIZED AND/OR ENCAPSULATED HAPTIC ACTUATORS AND ELEMENTS**
LOKALISIERTE UND/ODER VERKAPSELTE HAPTISCHE AKTUATOREN UND ELEMENTE
ACTIONNEURS ET ÉLÉMENTS HAPTIQUES LOCALISÉS ET/OU ENCAPSULÉS

(30) Priority: 20.06.2016 US 201662352046 P; 11.07.2016 US 201662360836 P
(43) Date of publication of application: 27.12.2017
(73) Proprietor: Apple Inc., Cupertino CA 95014 (US)
(72) Inventor: Wen, Xiaonan, Cupertino, CA 95014 (US); Lin, Wei, Cupertino, CA 95014 (US); Pedder, James Edward Alexander, Cupertino, CA 95014 (US); Niu, Xiaofan, Cupertino, CA 95014 (US); Gupta, Nathan K., Cupertino, CA 95014 (US); Chen, Po-Jui, Cupertino, CA 95014 (US); Rumford, Robert W., Cupertino, CA 95014 (US); Gupta, Pavan O., Cupertino, CA 95014 (US); Yang, Jui-Ming, Cupertino, CA 95014 (US)
(74) Representative: Lang, Johannes

(56) References cited:
- EP-A1- 2 385 445
- US-A- 6 069 433
- US-A1- 2011 080 347
- US-A1- 2012 105 333
- US-A1- 2013 162 543

## Description

### FIELD

The described embodiments relate generally to haptic actuators and/or various other haptic systems for electronic devices. More particularly, the present embodiments relate to haptic actuators that include electrode patterning for generating localized haptic output and/or encapsulated elements of a haptic output system.

### BACKGROUND

Electronic devices include a variety of different input/output devices to receive input from users and/or provide output to users. Examples of input/output devices include touch screens, keyboards, computer mice, trackpads, track balls, microphones, speakers, touch pads, force sensors, buttons, and so on.

Some electronic devices include actuators and/or various haptic output systems for providing tactile or other haptic output to a user. The haptic output may be provided as feedback in response to received input, as notifications regarding received communications or other electronic device statuses, and so on. The electronic device can activate the system to solicit a user's attention, enhance the user's interactive experience with the electronic device, displace the electronic device or a component of the electronic device, or for any other suitable notification or user experience purpose.

In some cases, a haptic output system may be partially or entirely encapsulated to provide mechanical, electrical, or chemical protection to one or more of its constituent components or elements. However, conventional encapsulation techniques and materials can undesirably interfere with the operation of the haptic output system.

Patent application publication US 2013/0 162 543 A1discloses an apparatus including a flexible circuit having a flexible substrate and at least one electrical conductor; and a least one piezoelectric member adapted to move when a voltage is applied to the piezoelectric member. The piezoelectric member is mounted to a first side of the flexible substrate and electrically connected to at least one of the electrical conductors.

Patent application publication US 2011/0 080 347 A1discloses a piezoelectric assembly including an electrode assembly, a signal electrical connector, and a reference electrical connector.

Patent publication US 6,069,433 discloses a packaged strain actuator including one or more plates or elements of electro-active material bonded to an electroded sheet, preferably by a structural polymer to form a card.

Patent application publication US 2012/0 105 333 A1discloses methods and systems for providing haptic control.

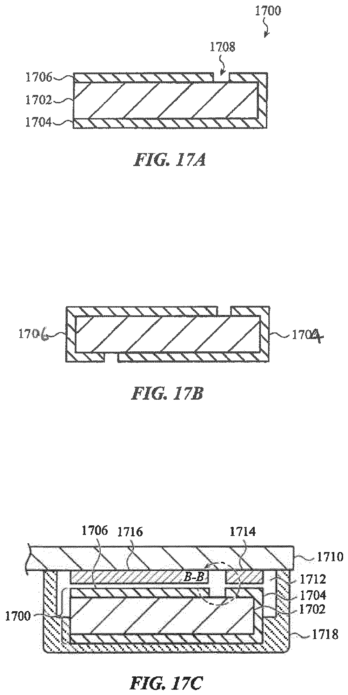

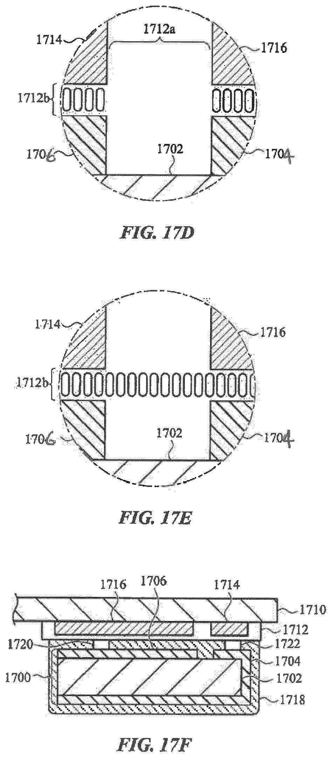

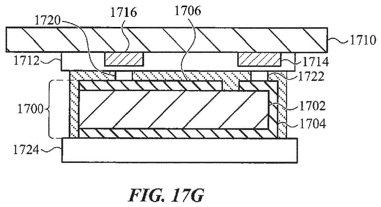

EP 2 385 445 A1 discloses a shear-mode transducer for generating or receiving an acoustic edge wave in a touch sensor having a substrate with a first surface having a touch region and a second surface intersecting the first surface along a first edge, the acoustic edge wave propagating along the first edge, wherein the shear-mode transducer is mounted on the substrate on the second surface, and comprises a shear-mode piezoelectric element, the shear-mode piezoelectric element providing shear motion in a direction relative to a plane of the second surface defined by X and Y axes so as to couple to the acoustic edge wave, wherein the shear-mode transducer further comprises a first electrode and a second electrode disposed on the shear-mode piezoelectric element to provide an active region of the shear-mode piezoelectric element, said active region comprising a cross-sectional area of the acoustic edge wave. The present invention is defined by the features of the independent claim(s). Preferred advantageous embodiments thereof are defined by the sub-features of the dependent claims. The invention is defined in figures 17C, 17F, 17G and the paragraphs describing them. Any other reference to "embodiment(s)", "example(s)" or "aspect(s) of the invention" in this description shall be interpreted as illustrative example(s) for understanding the invention.

### SUMMARY

The present disclosure relates to localized and/or encapsulated haptic actuators or elements. More particularly, embodiments discussed herein relate to haptic actuators that include electrode patterning for generating localized haptic output and/or encapsulated elements of a haptic output system.

In localized haptic actuator embodiments, a haptic actuator for an electronic device includes piezoelectric material and voltage electrodes or conductors coupled thereto. The voltage electrodes are individually controllable to supply voltage to different portions of the piezoelectric material. Different sections of the piezoelectric material are operable to deflect, producing haptic output at those locations, in response to the application of the voltage. Differing voltages may be provided to one or more of the voltage electrodes to affect the location of the deflection, and thus the haptic output. This may allow greater haptic resolution within the dimensions of the physically contiguous piezoelectric material while producing the magnitude of deflection associated with larger monolithic piezoelectric structures.

In various implementations, a portable electronic device includes a cover glass and a haptic actuator coupled to the cover glass. The haptic actuator includes piezoelectric material and a pattern of voltage electrodes coupled to the piezoelectric material. The voltage electrodes of the pattern of voltage electrodes are individually controllable. The pattern of voltage electrodes is operable to supply voltage to different portions of the piezoelectric material to deform the piezoelectric material at one of multiple different locations.

In some examples, the different portions of the piezoelectric material provide tactile outputs via the cover glass when voltage is supplied. In numerous examples, the piezoelectric material is operable to deflect based on where the voltage is supplied. In some implementations of such examples, varying the voltage supplied via different of the voltage electrodes changes which of the different portions of the piezoelectric material deflect. In some examples, the piezoelectric material is physically continuous.

In numerous examples, the voltage electrodes cover a majority of a positive polar surface of the piezoelectric material. In various examples, the haptic actuator further includes a pattern of ground electrodes that cover a majority of a negative polar surface of the piezoelectric material.

In some implementations, an electronic device includes a piezoelectric wafer having a surface, voltage electrodes that cover a portion of the surface and define gaps between each other, and a processing unit electrically coupled to the voltage electrodes. The processing unit is operable to produce deflections at different sections of the piezoelectric wafer by varying voltages supplied to the voltage electrodes.

In various examples, the voltage electrodes are shaped to correspond to a haptic output area. In some examples, the electronic device is a trackpad. In other examples, the electronic device is a keyboard.

In numerous examples, the processing unit produces a deflection at a section of the piezoelectric wafer covered by a first voltage electrode of the voltage electrodes by supplying voltage to the first voltage electrode and no voltage to other voltage electrodes adjacent to the first voltage electrode. In other examples, the processing unit produces a deflection at a section of the piezoelectric wafer covered by supplying a higher voltage to a first voltage electrode of the voltage electrodes and a lower voltage to other voltage electrodes of the voltage electrodes. In still other examples, the processing unit produces a deflection at a section of the piezoelectric wafer covered by a first voltage electrode of the voltage electrodes by supplying a first voltage to the first voltage electrode, a second voltage to a second voltage electrode of the voltage electrodes, and a third voltage to other voltage electrodes of the voltage electrodes wherein the third voltage is higher than the second voltage and lower than the first voltage.

In various implementations, a haptic actuator includes a piezoelectric substrate (such as lead zirconate titanate, potassium-based piezoelectric materials such as potassium-sodium niobate, and/or any other suitable piezoelectric material), a first voltage conductor coupled to a surface of the piezoelectric substrate, and a second voltage conductor coupled to the surface of the piezoelectric substrate and separated from the first voltage conductor. The piezoelectric substrate produces haptic output at different locations depending on voltages of the first and second voltage conductors.

In some examples, the haptic actuator further includes a third voltage conductor coupled to the surface of the piezoelectric substrate separated from the first voltage conductor and a fourth voltage conductor coupled to the surface of the piezoelectric substrate separated from the second voltage conductor. In such examples, a cross pattern may be defined by separations between the first, second, third, and fourth voltage conductors.

In numerous examples, the haptic actuator further includes a ground conductor coupled to an additional surface of the piezoelectric substrate that is opposite the surface. In some implementations of such examples, the ground conductor is a first ground conductor positioned opposite the first voltage conductor and a second ground conductor positioned opposite the second voltage conductor. In other implementations of such examples, the ground conductor is a common ground for the first and second voltage conductors.

In haptic output system encapsulated element embodiments, a sealed haptic element includes at least a piezoelectric component. The piezoelectric component may include a piezoelectric sheet, a first electrode formed on a first face of the sheet, and a second electrode formed on a second face of the sheet. The haptic element may include a first flex with a first contact positioned relative to the first face such that the first electrode of the piezoelectric component and the first contact of the flex are electrically connected.

Similarly, haptic components may include a second flex with a second contact positioned relative to the second face of the piezoelectric component such that the second electrode and the second contact are electrically connected. The haptic element may also include a seal disposed around a periphery of the piezoelectric component, between the first flex and the second flex, such that the first flex, the second flex, and the seal enclose the piezoelectric component.

Methods for sealing a haptic element may include encapsulating a piezoelectric component with a suitable encapsulant material. Thereafter, the component may be attached to a flexible circuit with an anisotropic conductive tape. The anisotropic conductive tape may establish an electrical connection between two electrodes of the encapsulated component and two electrical contacts on the flex.

In various implementations, a haptic element includes a piezoelectric component, a first flex including a first contact, a second flex including a second contact, and a seal disposed around a periphery of the piezoelectric component and between the first flex and the second flex such that the first flex, the second flex, and the seal enclose the piezoelectric component. The piezoelectric component includes a piezoelectric sheet, a first electrode formed on a first face of the sheet, and a second electrode formed on a second face of the sheet. The first flex is positioned relative to the first face such that the first electrode and the first contact are electrically connected. The second flex is positioned relative to the second face such that the second electrode and the second contact are electrically connected.

In some examples, the first contact is coupled to the first electrode via an anisotropic film. In various examples, the first contact is coupled to the first electrode via a bonding agent.

In numerous examples, the seal is separated from a sidewall of the piezoelectric component so as to define a gap between the seal and the sidewall. In some examples, the seal conforms to a sidewall of the piezoelectric component. In various examples, the seal is formed from a flexible material.

In some examples, the haptic element is a member of a group of haptic elements associated with a haptic output system. The haptic output system may be configured to be disposed below a display of a portable electronic device.

In some implementations, a haptic element includes a piezoelectric component, a flex comprising a first contact and a second contact, and an encapsulation layer disposed over the piezoelectric component thereby enclosing the piezoelectric component against the flex. The piezoelectric component includes a piezoelectric sheet, a first electrode formed on a first face of the sheet, and a second electrode having a first portion formed on a second face of the sheet and having a second portion formed on the first face of the sheet. The flex is positioned relative to the first face such that the first electrode and the first contact are electrically connected and the second electrode and the second contact are electrically connected.

In various examples, the haptic element further includes an anisotropic film positioned between the first contact and the first electrode. The anisotropic film may extend between the second contact and the second electrode.

In numerous examples, the haptic element further includes a bonding material positioned between the first contact and the first electrode. The bonding material may be an electrically conductive adhesive. The bonding material may be anisotropically conductive.

In numerous implementations, a haptic output system includes an input surface and an array of haptic elements subjacent the input surface. Each haptic element of the array of haptic elements includes a piezoelectric component comprising an electrode, a flex comprising an electrical contact electrically connected to the electrode, and an encapsulation layer disposed over the piezoelectric component and in contact with the flex, thereby enclosing the piezoelectric component against the flex.

In some examples, the encapsulation layer of at least one haptic element of the array of haptic elements is between the flex and the piezoelectric component. In numerous examples, the encapsulation layer of at least one haptic element of the array of haptic elements is formed from a polymer material.

In various examples, the haptic output system further includes a display. The display may be disposed between the input surface and the array of haptic elements.

In numerous examples, the electrode of at least one haptic element of the array of haptic elements is a wrap-around electrode. In some examples, at least one haptic element of the array of haptic elements comprises an interposer electrically connecting the electrode to the electrical contact.

### BRIEF DESCRIPTION OF THE DRAWINGS

The disclosure will be readily understood by the following detailed description in conjunction with the accompanying drawings, wherein like reference numerals designate like structural elements.
FIG. 1 depicts an example electronic device that includes a haptic actuator.
FIG. 2 depicts an example cross-sectional view of the electronic device of FIG. 1, taken along line A-A of FIG. 1.
FIG. 3 depicts a top view of an example implementation of one of the haptic actuators of the electronic device of FIG. 2.
FIG. 4 depicts a front side view of the example haptic actuator of FIG. 3.
FIG. 5 depicts actuation of one of an example array of haptic actuators.
FIG. 6 depicts actuation of an example single large haptic actuator.
FIG. 7A depicts actuation of a first section of the example haptic actuator of FIG. 3.
FIG. 7B depicts actuation of a second section of the example haptic actuator of FIG. 3.
FIG. 7C depicts actuation of a third section of the example haptic actuator of FIG. 3.
FIG. 8 depicts a side view of a second example implementation of one of the haptic actuators of the electronic device of FIG. 2.
FIG. 9 depicts a third example haptic actuator.
FIG. 10 is a flow chart illustrating an example method for constructing a haptic actuator. This method may assemble one or more of the haptic actuators of FIGs. 2-4 and 7A-9.
FIG. 11 is a flow chart illustrating an example method for providing output using a haptic actuator. This method may be performed by the electronic device of FIGs. 1-2 and/or one or more of the haptic actuators of FIGs. 2-4 and 7A-9.
FIG. 12A depicts an electronic device with an input surface through which haptic output can be provided to a user.
FIG. 12B depicts the electronic device of FIG. 12A, showing a haptic output system in phantom below the input surface.
FIG. 13A depicts a simplified cross-section of a piezoelectric component of a haptic element.
FIG. 13B depicts the piezoelectric component of FIG. 13A, particularly showing a top flex and a bottom flex electrically coupled to a top electrode and a bottom electrode of the piezoelectric component.
FIG. 14A depicts an example detail view, in cross-section, of an electrically conductive bond between an electrical contact of a flex and an electrode of a piezoelectric component of a haptic element such as described herein.
FIG. 14B depicts an example detail view, in cross-section, of another electrically conductive bond between an electrical contact of a flex and an electrode of a piezoelectric component of a haptic element such as described herein.
FIG. 15A depicts a simplified cross-section of a sealed haptic element, particularly showing a sidewall seal connecting a top flex to a bottom flex around a periphery of a piezoelectric component.
FIG. 15B depicts a simplified cross-section of another sealed haptic element, particularly showing another sidewall seal connecting a top flex to a bottom flex around a periphery of a piezoelectric component.
FIG. 15C depicts a simplified cross-section of another sealed haptic element, particularly showing a two-part sidewall seal connecting a top flex to a bottom flex around a periphery of a piezoelectric component.
FIG. 15D depicts a simplified cross-section of another sealed haptic element, particularly showing another sidewall seal connecting a top flex to a bottom flex conforming to a periphery of a piezoelectric component.
FIG. 16A depicts a simplified cross-section of an encapsulated haptic element.
FIG. 16B depicts a simplified cross-section of another encapsulated haptic element.
FIG. 17A depicts a simplified cross-section of a piezoelectric component with a wrap-around electrode.
FIG. 17B depicts a simplified cross-section of a piezoelectric component with multiple wrap-around electrodes.
FIG. 17C depicts a simplified cross-section of a haptic element incorporating the piezoelectric component of FIG. 17A, particularly showing the piezoelectric component coupled to a flex and encapsulated.
FIG. 17D depicts a detail view of the enclosed circle B-B shown in FIG. 17C, specifically illustrating an anisotropic sheet formed with conductive portions and non-conductive portions.
FIG. 17E depicts a detail view of the enclosed circle B-B shown in FIG. 17C, specifically illustrating an anisotropic sheet.
FIG. 17F depicts a simplified cross-section of another haptic element incorporating the piezoelectric component of FIG. 17A, particularly showing the piezoelectric component encapsulated prior to coupling to a flex.
FIG. 17G depicts a simplified cross-section of another haptic element incorporating the piezoelectric component of FIG. 17A, particularly showing the piezoelectric component coupled to a flex and encapsulated.
FIG. 18 is a simplified flow chart depicting example operations of a method of encapsulating a piezoelectric part.
FIG. 19 is a simplified flow chart depicting example operations of another method of encapsulating a piezoelectric part.
FIG. 20 is a simplified flow chart depicting example operations of another method of a piezoelectric part.
FIG. 21 is a simplified flow chart depicting example operations of another method of a piezoelectric part.

The use of the same or similar reference numerals in different figures indicates similar, related, or identical items.

The use of cross-hatching or shading in the accompanying figures is generally provided to clarify the boundaries between adjacent elements and also to facilitate legibility of the figures. Accordingly, neither the presence nor the absence of cross-hatching or shading conveys or indicates any preference or requirement for particular materials, material properties, element proportions, element dimensions, commonalities of similarly illustrated elements, or any other characteristic, attribute, or property for any element illustrated in the accompanying figures.

Additionally, it should be understood that the proportions and dimensions (either relative or absolute) of the various features and elements (and collections and groupings thereof) and the boundaries, separations, and positional relationships presented therebetween, are provided in the accompanying figures merely to facilitate an understanding of the various embodiments described herein and, accordingly, may not necessarily be presented or illustrated to scale, and are not intended to indicate any preference or requirement for an illustrated embodiment to the exclusion of embodiments described with reference thereto.

### DETAILED DESCRIPTION

Reference will now be made in detail to representative embodiments illustrated in the accompanying drawings. It should be understood that the following descriptions are not intended to limit the embodiments to one preferred embodiment. To the contrary, it is intended to cover alternatives, modifications, and equivalents as can be included within the scope of the described embodiments as defined by the appended claims.

The description that follows includes sample apparatuses, systems, and methods that embody various elements of the present disclosure. However, it should be understood that the described disclosure may be practiced in a variety of forms in addition to those described herein.

The following disclosure relates to localized and/or encapsulated haptic actuators or elements. More particularly, embodiments discussed herein relate to haptic actuators that include electrode patterning for generating localized haptic output and/or encapsulated elements of a haptic output system.

In localized haptic actuator embodiments, a haptic actuator includes piezoelectric material and a patterned electrode. The patterned electrode can apply voltage to different portions of the piezoelectric material. This allows localized haptic output as the location where a maximum deflection is produced in the piezoelectric material depends on the voltages applied.

Some actuators provide haptic output by applying voltage to piezoelectric material. Many such actuators include a single flood electrode that applies voltage to an entire surface of the piezoelectric material simultaneously. In such examples, the piezoelectric material deflects in response to the application of voltage to provide the haptic output.

The amount of deflection that can be produced, and thus the magnitude of haptic output, may be dependent on the amount of voltage applied, piezoelectric wafer size, number of layers of piezoelectric material, and so on. When haptic actuators are limited to relatively lower voltages and single layers of piezoelectric material, the wafer size of the piezoelectric material may be the only factor that can be adjusted. Wafers of smaller than a particular set of dimensions may not produce sufficient deflection to be adequately perceptible as haptic feedback. Thus, haptic actuators may be designed with wafers as large as possible.

However, these kinds of haptic actuators may produce haptic output at a single location due to the single flood electrode. In order to produce haptic output at different locations, multiple actuators may be used. Due to the wafer size sufficient to produce detectable haptic output, the number of actuators that fit within a space may be limited. Thus, there may be a tradeoff between the magnitude of haptic output that can be produced and the number of different locations where haptic output can be produced.

Due to the patterned electrode being able to apply voltage to different portions of the piezoelectric material, the haptic actuator of the present location can use larger wafer sizes while still being able to generate haptic output at multiple locations. This allows haptic output to be produced with greater magnitude without sacrificing localization of haptic output.

In haptic output system encapsulated element embodiments, one or more fragile or sensitive components of a haptic output system that may be included in an electronic device may be packaged, sealed, and/or encapsulated.

Encapsulations such as described herein can be configured, in any implementation-specific or appropriate manner, to provide thermal, mechanical, electrical, optical, and/or chemical protection to a fragile or sensitive component of a haptic output system. A piezoelectric component is an example of a fragile or sensitive component of a haptic output system that can be encapsulated and/or sealed using techniques such as those described herein. However, it may be appreciated that the various techniques and methods described herein may be equally applicable to other components of a haptic output system, or to another system or subsystem that may be incorporated by an electronic device.

In one embodiment, a piezoelectric component includes a sheet of piezoelectric material and two electrodes defined on opposite faces of the sheet. For example, a top electrode can be formed on a top face of the sheet and a bottom electrode can be formed on a bottom face of the sheet. This configuration is referred to herein as a piezoelectric component with "opposing electrodes."

In other cases, the bottom electrode can wrap around a sidewall of the piezoelectric sheet. In these embodiments, the top electrode and the bottom electrode both occupy a portion of the top face of the sheet. This configuration is referred to herein as a piezoelectric component with a "wrap-around electrode."

In one example, a piezoelectric component with opposing electrodes can be encapsulated by laminating the component between a top flex and a bottom flex. A first electrical connection can be made between the top electrode and the top flex, and a second electrical connection can be made between the bottom electrode and the bottom flex. In some cases, the first electrical connection is established using the same technique used to establish the second electrical connection.

The first and second electrical connections can be established using any number of suitable techniques including, but not limited to, soldering, welding, bonding with electrically conductive adhesive, bonding with electrically conductive tape, placing electrically conductive surfaces in contact, and so on. In some cases, the first and second electrical connections can be formed in the same operation, such as the lamination operation described above.

In a further embodiment, a sealant can be added around the perimeter of the piezoelectric component, between the top flex and the bottom flex. The sealant can be a polymer-based sealant, an epoxy-based sealant, a poly-silicone based sealant, a resin-based sealant, or any other suitable sealant material or combination of materials. In some embodiments, only one layer of sealant is used. The sealant can contact sidewalls of the piezoelectric component, or the sealant can be separated from sidewalls of the piezoelectric component by an air gap. In some cases, the gap between the sidewalls of the piezoelectric component and the sealant can be filled with a gas (e.g., nitrogen, helium and so on), a gel (e.g., polymer gel), or liquid (e.g., mineral oil, glycerin). The pressure of the gas, gel, or liquid can vary from embodiment to embodiment.

In other cases, an adhesive ring can be positioned on the top flex. The operation of laminating the piezoelectric component between the top flex and the bottom flex can cause the adhesive ring to bond the bottom flex to the top flex, thereby enclosing the piezoelectric component in a volume defined between the top flex and the bottom flex. In further embodiments, an adhesive ring can also be disposed onto the bottom flex. In this case, the operation of laminating the piezoelectric component between the top flex and the bottom flex can cause the two adhesive rings to bond to one another.

In another example, a piezoelectric component with opposing electrodes can be encapsulated by laminating the component to a single flex. A first electrical connection can be made between the top electrode and the flex, and a second electrical connection can be made between the bottom electrode and an interposer. The interposer may be electrically connected to the flex. In these embodiments, the piezoelectric component and the interposer may be coated by an encapsulant layer (e.g., forming an encapsulation layer).

In another example, a piezoelectric component with a wrap-around electrode can be encapsulated by laminating the component to a single flex. A first electrical connection can be made between the top electrode and a first electrical contact on the flex, and a second electrical connection can be made between the wrap-around bottom electrode and a second electrical contact on the flex. In these embodiments, the piezoelectric component can be coated by an encapsulant layer before or after the first and second electrical connections are established.

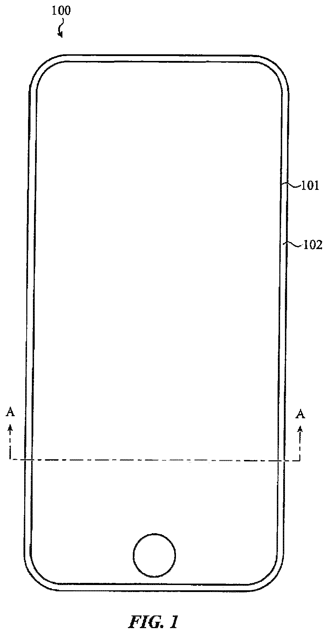

These and other embodiments are discussed below with reference to FIGs. 1 - 21. However, those skilled in the art will readily appreciate that the detailed description given herein with respect to these Figures is for explanatory purposes only and should not be construed as limiting.

FIG. 1 depicts an example electronic device 100 that includes one or more haptic actuators. In this example, the electronic device 100 is a portable device including a cover glass 101 coupled to a housing 102. The cover glass 101 may be a component of a touch screen or similar component and the haptic actuator(s) may be operable to provide tactile or other haptic output via the cover glass 101.

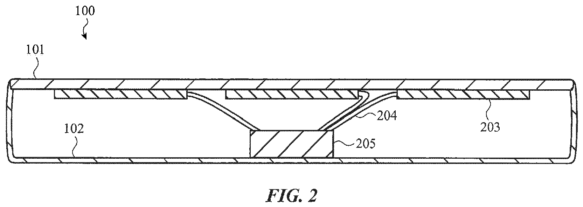

FIG. 2 depicts an example cross-sectional view of the electronic device 100 of FIG. 1, taken along line A-A of FIG. 1. The electronic device 100 includes a number of haptic actuators 203. The haptic actuators 203 may include piezoelectric material that is operable to deflect when voltage is supplied by a processing unit 205 or other controller via flex circuits 204 or other electrical connections. The deflection may be transferred through the cover glass 101 to produce haptic output to a user. Thus, the processing may be electrically coupled to the haptic actuators 203 to produce deflections by supplying voltages to the haptic actuators 203.

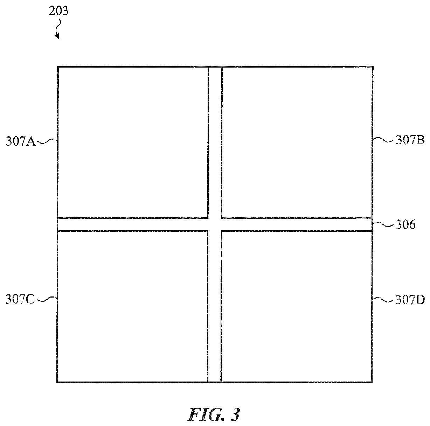

FIG. 3 depicts a top view of an example implementation of one of the haptic actuators 203 of the electronic device of FIG. 2. The haptic actuator 203 may include a wafer, substrate, or other structure of piezoelectric material 306, such as lead zirconate titanate ("PZT"), potassium-based piezoelectric materials such as potassium-sodium niobate, and/or any other suitable piezoelectric material. In many implementations, the piezoelectric material 306 may be physically continuous. The haptic actuator 203 may also include a pattern of voltage electrodes 307A-307D or conductors coupled to a positive polar surface of the piezoelectric material 306. In this example, the voltage electrodes 307A-307D may cover a portion of the surface of the piezoelectric material 306 (shown as a majority of the surface), separated from each other such that a cross pattern is defined by the separations between the first, second, third, and fourth voltage electrodes 307A-307D.

Due to the pattern of the voltage electrodes 307A-307D and the separations in between, the voltage electrodes 307A-307D may be individually controllable to supply different voltages to different portions of the piezoelectric material 306 (e.g., the portion covered by the respective voltage electrode 307A-307D). As such, deflections or deformations (e.g., tactile or other haptic output) may be produced at different sections (e.g., or more of multiple different locations) of the piezoelectric material 306 by providing various voltages to the various portions of the piezoelectric material 306. The location of the deflections or deformations may depend on where the voltages are applied. Further, varying the voltages may change which portions of the piezoelectric material 306 deflects.

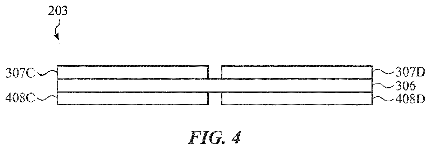

FIG. 4 depicts a front side view of the example haptic actuator 203 of FIG. 3. The haptic actuator 203 may further include one or more ground electrodes 408A-408D (408C-408D shown) or conductors coupled to an additional surface, such as a negative polar surface, opposite the surface where the voltage electrodes 307A-307D are coupled. In this example, a respective ground electrode 408A-408D is included for each of the voltage electrodes 307A-307D, each positioned opposite their respective voltage electrode 307A-307D.

The ground electrodes 408A-408D may cover a majority of the negative polar surface of the piezoelectric material 306. The ground electrodes 408A-408D may be separated from each other such that the separations define a cross pattern similar to that defined by the voltage electrodes 307A-307D on the positive polar surface of the piezoelectric material 306.

Though not illustrated for the purposes of clarity, the haptic actuator may also include one or more stiffener components. The stiffener component may be formed of non-piezoelectric materials such as plastic, metal, and so on. The stiffener component may be coupled or otherwise bonded to the surface of the piezoelectric material 306 and/or the additional surface of the piezoelectric material 306. For a free boundary piezoelectric actuator, when applying electrical field in the poling direction, x and y dimensions may contract (e.g., the dimensions of the piezoelectric material 306 illustrated in FIG. 3) and the z dimension may expand (e.g., the vertical dimension of the piezoelectric material 306 shown in FIG. 4). The form factor of the piezoelectric material 306 in the example haptic actuator 203 of FIGs. 3 and 4 may be relatively large in the x and y dimensions as shown, but relatively thin in the z dimension. As a result, under a free boundary condition, deflection or deformation in the z dimension may be relatively small absent inclusion of a stiffener component. However, coupling the stiffener component bonded to the surface of the piezoelectric material 306 and/or the additional surface of the piezoelectric material 306 may transform the x-y contraction to z direction deflection, deformation, or other actuation.

The deflections possible using the haptic actuator 203 due to the piezoelectric material 306 and the pattern of voltage electrodes 307A-307D will now be contrasted with other configured haptic actuators. The haptic actuator 203 will be contrasted against an array of smaller haptic actuators that each include a single flood electrode and a monolithic haptic actuator with a single flood electrode.

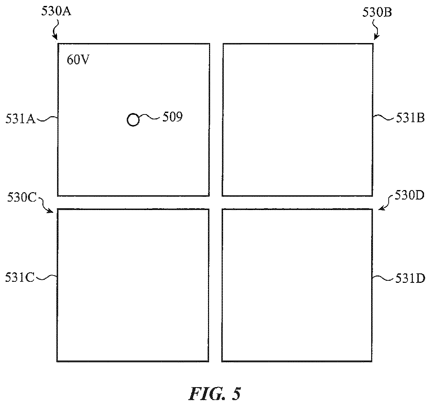

FIG. 5 depicts actuation of one of an example array of haptic actuators 530A-530D. In this example, each haptic actuator 530A-530D includes a single respective flood electrode 531A-531D that can supply voltage to the entirety of piezoelectric material included in the respective haptic actuator 530A-530D. Supplying voltage to one of the respective flood electrodes 531A-531D causes a deflection in the respective haptic actuator 530A-530D.

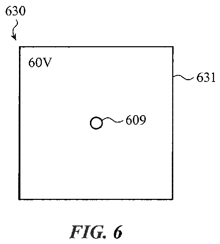

Similarly, FIG. 6 depicts actuation of an example single large haptic actuator 630. In this example, the haptic actuator 630 includes a single respective flood electrode 631 that can supply voltage to the entirety of piezoelectric material included in the haptic actuator 630. Supplying voltage to the flood electrode 631 causes a deflection in the haptic actuator 630.

For purposes of contrasting the haptic actuator 203 of FIGs. 2-4 with the array of haptic actuators 530A-530D of FIG. 5 and the single large haptic actuator 630 of FIG. 6, example dimensions will be assumed for the purposes of comparison. By way of example, example dimensions of the haptic actuator 203 of FIGs. 2-4 will be assumed such that the haptic actuator 203 has a side length of approximately 40 millimeters. Similarly, example dimensions of the haptic actuators 530A-530D of FIG. 5 will be assumed to each have a side length of approximately 10 millimeters and the single large haptic actuator 630 of FIG. 6 will be assumed to have a side length of approximately 40 millimeters. In this way, different deflections for comparable dimensions of piezoelectric material can be demonstrated. However, it is understood that these assumed dimensions are for the purposes of example and are not intended to be limiting.

Assuming these example dimensions, FIG. 5 illustrates a peak deflection 509 produced in the haptic actuator 530A of approximately 10 microns when 60 volts is applied to the haptic actuator 530A. By way of contrast, FIG. 6 illustrates a peak deflection 609 produced in the haptic actuator 630 of approximately 160 microns when 60 volts is applied to the haptic actuator 630. Thus, the haptic actuator 630 is able to produce a peak deflection 609 (and thus a tactile or other haptic output) of a greater magnitude than the haptic actuator 530A.

However, the haptic actuator 630 is able to produce the peak deflection 609 at a single location. This means that the haptic resolution of the haptic actuator 630, given the assumed side length of approximately 40 millimeters, is of approximately 1/1600 millimeters squared. As each of the haptic actuators 530A-530D of the array of haptic actuators 530A-530D can each produce a peak deflection 509, the array of haptic actuators 530A-530D can produce peak deflections 509 at four different locations. Thus, given the assumed side length of approximately 10 millimeters for each of the array of haptic actuators 530A-530D, the array of haptic actuators 530A-530D have a haptic resolution of approximately 4/1600 millimeters squared. The tradeoff between the array of haptic actuators 530A-530D and the haptic actuator 630 is between the magnitude of peak deflection 509, 609 and haptic resolution.

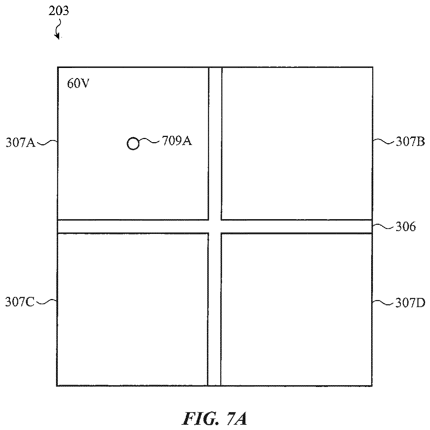

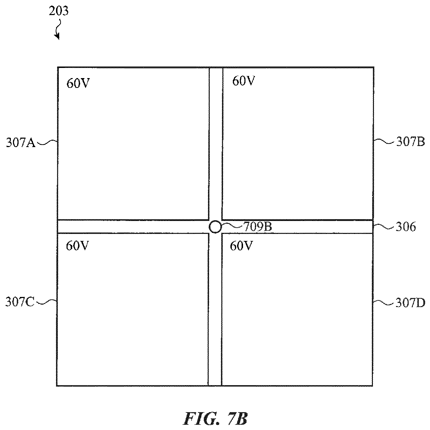

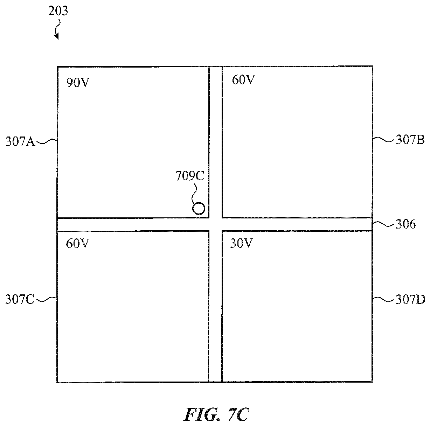

By way of contrast, FIG. 7A depicts actuation of a first section of the example haptic actuator 203 of FIG. 3 when 60 volts is applied to the piezoelectric material 306 via the first voltage electrode 307A. This produces a peak deflection 709A of 10 microns in the first section, corresponding to the first portion of the piezoelectric material 306 (e.g., the portion covered by the first voltage electrode 307A). FIG. 7B depicts actuation of a second section of the example haptic actuator 203 when 60 volts is applied to the piezoelectric material 306 via each of the voltage electrodes 307A-307D. This produces a peak deflection 709B of 160 microns at the second section of the piezoelectric material 306 (e.g., the portion in between all four voltage electrodes 307A-307D). FIG. 7C depicts actuation of a third section of the example haptic actuator 203 when 90 volts is applied to the first voltage electrode 307A, 6o volts is applied to the second voltage electrode 307B, 60 volts is applied to the third voltage electrode 307C, and 30 volts is applied to the fourth voltage electrode 307D. This produces a peak deflection 709C of 160 microns at the third section of the piezoelectric material 306 (e.g., the portion covered by the first voltage electrode 307A but closer to the location of the peak deflection 709B of FIG. 7B than the location of the peak deflection 709A of FIG. 7A).

Thus, the haptic actuator 203 can produce peak deflections 709A-709C and other peak deflections at a variety of different locations by supplying a variety of different voltages to one or more of the voltage electrodes 307A-307D. The haptic actuator 203 has an even higher haptic resolution than the array of haptic actuators 530A-530D of FIG. 5 and can produce deflections with magnitudes as high as and/or comparable to the haptic actuator 630 of FIG. 6.

The deflections produced by the haptic actuator 203 may be steerable. By providing voltage to a first voltage electrode 307A-307D of the voltage electrodes 307A-307D and no voltage to other voltage electrodes 307A-307D adjacent to the first voltage electrode 307A-307D, a peak deflection 709A can be produced at approximately the center of the portion of the piezoelectric material 306 covered by the respective electrode. Further, by providing approximately equivalent voltages to the voltage electrodes 307A-307D, a peak deflection 709B can be produced at the portion of the piezoelectric material 306 approximately between all the voltage electrodes 307A-307D. Additionally, by providing a higher voltage to a first voltage electrode 307A-307D of the voltage electrodes 307A-307D and lower voltages to other voltage electrodes 307A-307D, the peak deflection 709C can be steered towards the portion of the piezoelectric material 306 covered by the first voltage electrode 307A-307D. Moreover, by providing a first voltage to a first voltage electrode 307A-307D, a second voltage to a second voltage electrode 307A-307D that is comer-wise adjacent to the first voltage electrode 307A-307D, and a third voltage to other voltage electrodes 307A-307D that are side-wise adjacent to the first voltage electrode 307A-307D, the peak deflection 709C can be further steered towards the portion of the piezoelectric material 306 covered by the first voltage electrode 307A-307D. The location of the peak deflection may be adjustable, varied, altered, and so on by varying, adjusting, altering and so on the various voltages provided to the various voltage electrodes 307A-307D.

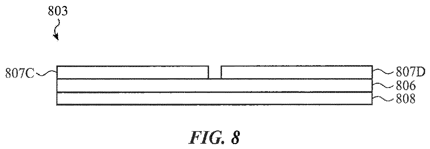

Although FIG. 4 is illustrated and described as including a separate ground electrode 408A-408D respectively associated with each of the voltage electrodes 307A-307D, it is understood that this is an example and other configurations are possible and contemplated. For example, FIG. 8 depicts a side view of a second example implementation of one of the haptic actuators 203 of the electronic device 100 of FIG. 2. In this example, a haptic actuator 803 includes a common ground electrode 808. The common ground electrode 808 may be common for all of the voltage electrodes 807A-807D. In some implementations, the common ground electrode 808 may cover all and/or substantially all of the surface of the piezoelectric material 806 opposing the surface to which the voltage electrodes 807A-807D are coupled.

FIG. 3 illustrates four voltage electrodes 307A-307D as square-shaped with separations between them defining a cross-shape. However, it is understood that this is an example. In various implementations, any number of voltage electrodes 307A-307D may be used of any shape that define various kinds of (and/or no) separations between them. In some implementations, the voltage electrodes 307A-307D may be shaped to correspond to designated haptic output areas. For example, the haptic actuator 203 may be used to provide haptic output for a keyboard in some implementations where the voltage electrodes 307A-307D are shaped to correspond to keys of the keyboard.

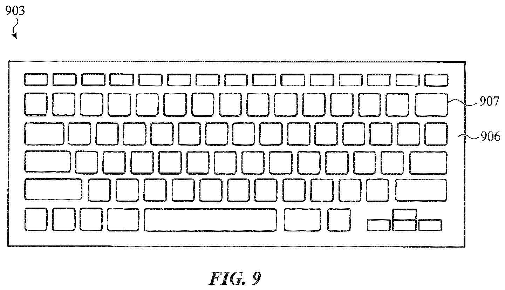

For example, FIG. 9 depicts a third example haptic actuator 903. The haptic actuator 903 includes a piezoelectric substrate 906 or wafer to which a pattern of voltage electrodes 907 is coupled. The voltage electrodes 907 may have shapes corresponding to the shapes of designated haptic output areas.

In some implementations, the haptic actuator 903 may be included in a keyboard and the voltage electrodes 907 may have shapes and locations corresponding to keys of the keyboard. In some examples of such implementations, the haptic actuator 903 may be dimensioned to correspond to the entire or substantially the entire keyboard, or a portion thereof. In other implementations, the haptic actuator 903 may be included in a trackpad, touch screen, touch pad, or other electronic device.

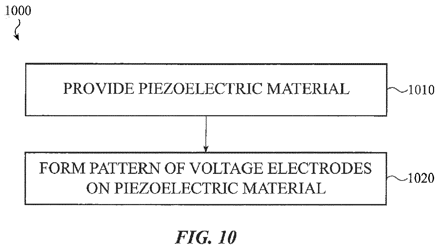

FIG. 10 is a flow chart illustrating an example method 1000 for constructing a haptic actuator. This method 1000 may assemble one or more of the haptic actuators of FIGs. 2-4 and 7A-9.

At 1010, piezoelectric material (such as a wafer, substrate, and so on) may be provided. Providing the piezoelectric material may include cutting the piezoelectric material from a larger structure of piezoelectric material. In some implementations, the piezoelectric material may be PZT.

At 1020, a pattern of voltage electrodes or conductors is formed on the piezoelectric material. The pattern may be formed on a single surface of the piezoelectric material, such as a positive polar surface. The pattern may be formed using a variety of different processes and/or techniques.

For example, a stencil or mask may be placed on the piezoelectric material and the pattern may be applied through the stencil, such as by printing, vapor deposition, sputtering, and so on. By way of a second example, conductive material may be formed on the piezoelectric material and then portions of the conductive material may be removed to form the pattern, such as by etching. In some cases, the etching or other removal may be performed through a stencil or mask. By way of a third example, light may be used to transfer the pattern from a photomask to a light-sensitive chemical photoresist or resist on the piezoelectric material.

By way of a fourth example, the pattern may be formed by defining a resist in an opposite pattern on the piezoelectric material upon which a conductive film is blanket-deposited before the resist is removed, leaving only the conductive film that was deposited directly on the piezoelectric material. By way of yet other examples, the pattern may be formed by metallization patterning, metallization, and/or other processes or techniques of forming conductive material on the piezoelectric material.

Although the example method 1000 is illustrated and described as including particular operations performed in a particular order, it is understood that this is an example. In various implementations, various orders of the same, similar, and/or different operations may be performed without departing from the scope of the present disclosure.

For example, in some implementations, the example method 1000 may include the additional operation of forming a ground electrode on the piezoelectric material. The ground electrode may be a common electrode, a pattern of ground electrodes, a pattern of ground electrodes corresponding to the pattern of voltage electrodes, and so on. The ground electrode may be formed on a ground surface of the piezoelectric material opposite the pattern of voltage electrodes.

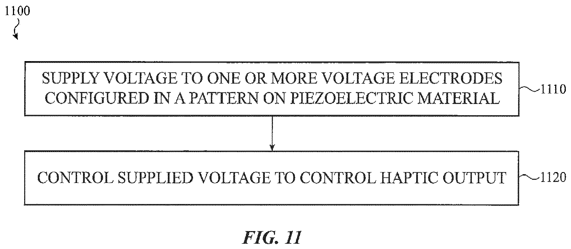

FIG. 11 is a flow chart illustrating an example method 1100 for providing output using a haptic actuator. This method 1100 may be performed by the electronic device of FIGs. 1-2 and/or one or more of the haptic actuators of FIGs. 2-4 and 7A-9.

At 1110, voltage is supplied to one or more voltage electrodes or conductors configured in a pattern on piezoelectric material, such as a wafer, substrate, and so on. The pattern may be positioned on a single surface of the piezoelectric material, such as the positive polar surface.

At 1120, the supplied voltage may be controlled to control haptic output. The supplied voltage may be supplied to one or more of the voltage electrodes and not others, supplied in different amounts to the different voltage electrodes, and so on.

Although the example method 1100 is illustrated and described as including particular operations performed in a particular order, it is understood that this is an example. In various implementations, various orders of the same, similar, and/or different operations may be performed without departing from the scope of the present disclosure.

For example, in some implementations, the example method 1100 may include the additional operation of varying the supplied voltage. Varying the supplied voltage may change the provided haptic output.

Although the electronic device 100 of FIGs. 1 and 2 is illustrated and described as a portable electronic device 100 such as a cellular telephone, it is understood that this is an example. In various implementations, the electronic device 100 may be any kind of electronic device 100. Examples include a laptop computing device, a smart phone, a wearable electronic device, a tablet computing device, a keyboard, a printer, a mouse, a mobile computing device, a trackpad, a touch pad, a touch screen, a digital media player, a display, and so on.

Further, although the electronic device 100 is illustrated and described as including particular components, it is understood that this is an example. In various implementations, the electronic device 100 may include other components, including one or more components not shown. Such additional components may include one or more communication components, one or more input/output components, one or more non-transitory storage media (which may take the form of, but is not limited to, a magnetic storage medium; optical storage medium; magnetooptical storage medium; read only memory; random access memory; erasable programmable memory; flash memory; and so on), one or more energy storage components, and so on.

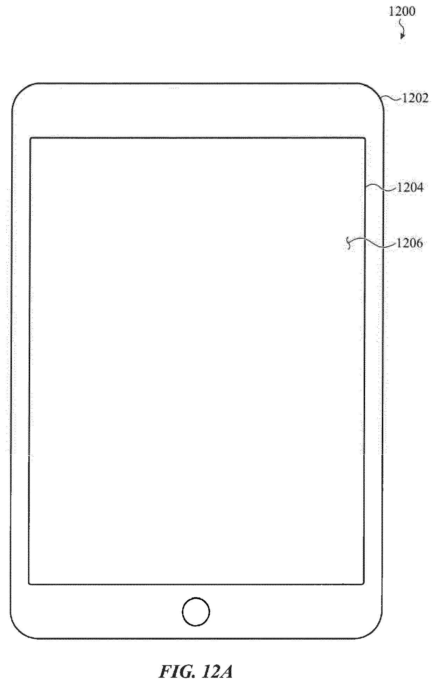

FIG. 12A shows an electronic device 1200 that can incorporate a haptic output system. The electronic device 1200 is illustrated as a tablet computing device, although this is not required and other electronic devices can incorporate a haptic output system including, but not limited to, wearable devices, cellular devices, peripheral input devices, vehicle control systems, industrial control systems, consumer appliances, industrial machinery, and so on.

In the illustrated embodiment, the electronic device 1200 includes a housing 1202 to retain, support, and/or enclose various components of the electronic device 1200, such as a display 1204. The display 1204 can include a stack of multiple layers including, for example, and in no particular order: an organic light emitting diode layer, a cover layer, a touch input layer, a force input layer, a biometric layer, and so on. Other embodiments can implement the display 1204 in a different manner, such as with liquid crystal display technology, electronic ink technology, quantum dot technology, and so on. In many embodiments, a protective outer layer of the display 1204 defines an input surface 1206.

The various layers of the display 1204, regardless of the implementation-specific display technology or technologies selected for a particular embodiment, may be adhered together with an optically transparent adhesive and/or may be supported by a common frame such that the layers abut one another. A common frame may extend around a perimeter, or a portion of the perimeter, of the layers, may be segmented around the perimeter, a portion of the perimeter, or may be coupled to the various layers of the display 1204 in another manner.

The common frame can be made from any suitable material such as, but not limited to: metal, plastic, ceramic, acrylic, and so on. The common frame may be a multi-purpose component serving an additional function such as, but not limited to: providing an environmental and/or hermetic seal to one or more components of the display 1204 or the electronic device 1200; providing structural support to the housing 1202; providing pressure relief to one or more components of the display 1204 or the electronic device 1200; providing and defining gaps between one or more layers of the display 1204 for thermal venting and/or to permit flexing of the layers in response to a force applied to the input surface 1206; and so on.

In some embodiments, the layers of the display 1204 may be attached or deposited onto separate substrates that may be laminated or bonded to each other. The display 1204 may also include or be positioned adjacent to other layers suitable for improving the structural or optical performance of the display 1204, including, but not limited to, a cover glass sheet, polarizer sheets, color masks, and the like. Additionally, the display 1204 may include a touch sensor (not shown) for determining the location of one or more touches on the input surface 1206 of the electronic device 1200. In many examples, the touch sensor is a capacitive touch sensor configured to detect the location and/or area of one or more touches of a user's finger and/or a passive or active stylus on the input surface 1206.

The electronic device 1200 can also include a processor, memory, power supply and/or battery, network connections, sensors, input/output ports, acoustic elements, haptic elements, digital and/or analog circuits for performing and/or coordinating tasks of the electronic device 1200, and so on. For simplicity of illustration, the electronic device 1200 is depicted in FIG. 1 without many of these elements, each of which may be included, partially and/or entirely, within the housing 1202 and may be operationally or functionally associated with, or coupled to, the display 1204.

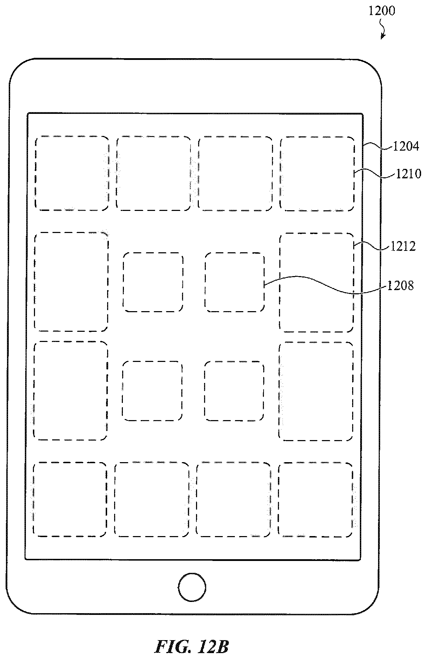

A haptic output system can be disposed below the input surface 1206 (see, e.g., FIGs. 12A and 12B). In the illustrated embodiment, the haptic output system includes sixteen independently-controllable haptic elements arranged in an array and positioned behind or within the display 1204. As a result of this arrangement, the haptic output system can provide localized haptic output to a user touching the display 1204. The haptic elements may be of any suitable size or shape. For example, three differently-sized and shaped haptic elements are identified as the haptic element 1208, the haptic element 1210, and the haptic element 1212.

The haptic elements of the haptic output system can be implemented in any number of suitable ways although, in many embodiments, each haptic element includes at least one piezoelectric component with either opposing electrodes or wrap-around electrodes. In many cases, the piezoelectric component of a haptic element is encapsulated. The encapsulation can be configured to provide thermal, mechanical, electrical, optical, and/or chemical protection to the piezoelectric component.

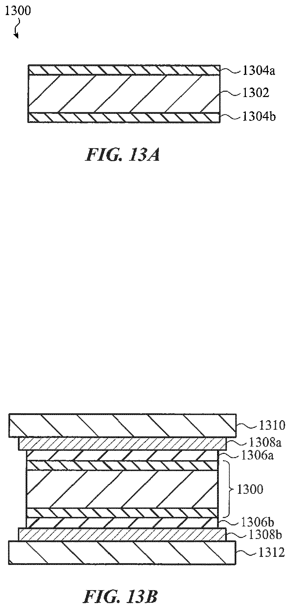

Generally and broadly, FIGs. 13A - 16B reference piezoelectric components with opposing electrodes, and, more specifically, methods and/or techniques of encapsulating a piezoelectric component with opposing electrodes. It will be appreciated, however, that the depicted examples are not exhaustive; the various embodiments depicted and described with reference to FIGs. 13A - 16B may be modified or combined in any number of suitable or implementation-specific ways to encapsulate, seal, pot, cast, or otherwise encase a piezoelectric component having opposing electrodes. In many cases, encapsulation of the piezoelectric component provides protection from, without limitation, metal corrosion, oxidation, contamination, scratching, or shattering.

FIG. 13A depicts a simplified cross-section of a piezoelectric component 1300 of a haptic element, such as the haptic element 1208 depicted in FIG. 12B. The piezoelectric component 1300 includes a sheet of piezoelectric material, labeled as the sheet 1302, and two electrodes defined on opposite faces of the sheet 1302. For example, a top electrode 1304a can be formed on a top face of the sheet 1302 and a bottom electrode 1304b can be formed on a bottom face of the sheet 1302.

The top electrode 1304a and the bottom electrode 1304b can be formed in any number of suitable ways. In one embodiment, the top electrode 1304a and the bottom electrode 1304b are thin-film layers formed by sputtering, physical vapor deposition, printing, or any other suitable technique. The top electrode 1304a and the bottom electrode 1304b are typically formed from metal or a metal alloy such as silver, silver ink, copper, copper-nickel alloy, and so on. In other embodiments, other conductive materials can be used.

In some embodiments, the piezoelectric component 1300 takes a different shape than that depicted. For example, the piezoelectric component 1300 may be 3cm in width and may be approximately 100µm thick.

FIG. 13B depicts the piezoelectric component 1300 of FIG. 13A encapsulated by two flexible circuits. In particular, the top electrode 1304a forms a first electrical connection, via a bonding material 1306a, with a top electrical contact 1308a that extends from a top flex 1310. Similarly, the bottom electrode 1304b forms a second electrical connection, via a bonding material 1306b, with a bottom electrical contact 1308b that extends from a bottom flex 1312.

The top flex 1310 and the bottom flex 1312 can be made from any number of suitable materials, but in many embodiments each is formed from a flexible circuit board material. In many cases the top flex 1310 and the bottom flex 1312 are sized to overhang sidewalls of the piezoelectric component 1300, although this may not be required. In many cases, one or both of the top flex 1310 and the bottom flex 1312 couple the piezoelectric component 1300 to a control circuit (not shown), or to another piezoelectric component 1300 in a master/slave configuration.

The top electrical contact 1308a and the bottom electrical contact 1308b are typically formed from copper or silver, although this may not be required and other metals or electrically conductive materials may be used. In many cases, the top electrical contact 1308a is connected to the top electrode 1304a in the same operation that connects the bottom electrical contact 1308b to the bottom electrode 1304b.

The bonding material 1306a, 1306b can be formed from any suitable electrically conductive material or combination of materials such as, but not limited to: electrically conductive adhesive, electrically conductive tape or film (isotropic or anisotropic), solder, and so on. In other cases, one or both of the bonding material 1306a, 1306b may be non-conductive. In these examples, the piezoelectric component 1300 can be driven capacitively. In other cases, non-conductive bonding material can be used to hold the top electrode 1304a in contact with the top electrical contact 1308a and, similarly, the bottom electrode 1304b in contact with the bottom electrical contact 1308b.

It may be appreciated that that the thickness and/or placement of the bonding material 1306a, 1306b may vary from embodiment to embodiment; the illustrated proportions of the bonding material 1306a, 1306b are not required. Further, it may be appreciated that the bonding material 1306a, 1306b may be disposed at another location, such as along the sidewalls of the piezoelectric component 1300. In another example, the bonding material 1306a, 1306b may be disposed to overflow beyond the faces of the piezoelectric component 1300.

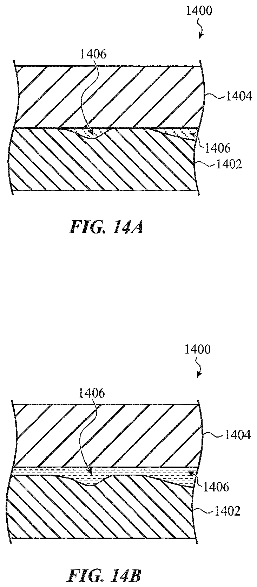

Accordingly, it is understood that the bonding material 1306a, 1306b as depicted in FIG. 13B broadly represents an electrical and/or mechanical element or layer (or combination of elements or layers) that establishes and/or maintains an electrical connection between an electrode of a piezoelectric component and an electrical contact of a flex or other circuit. Examples of such an electrical connection are provided in FIGs. 14A - 14B.

FIG. 14A depicts an electrical connection 1400 established between an electrode 1402 of a piezoelectric component (not shown) and an electrical contact 1404 of a flex (not shown). In the illustrated embodiment, a bonding material 1406 is disposed into cavities or surface features or imperfections of the electrode 1402. As a result, a top surface of the electrode 1402 is placed in direct contact with a bottom surface of the electrical contact 1404. The bonding material 1406 can be a conductive or non-conductive bonding agent such as liquid adhesive (e.g., epoxy). In some cases, the top surface of the electrode 1402 may be scored or otherwise prepared to receive the bonding material 1406. In some cases, the bonding material 1406 can be disposed to a particular thickness, such as shown in FIG. 14B. In this example, the bonding material 1406 can be a conductive bonding material such as isotropic or anisotropic conductive file, electrically conductive adhesive, epoxy doped with metal fibers or nanowires, or any other suitable electrically conductive material.

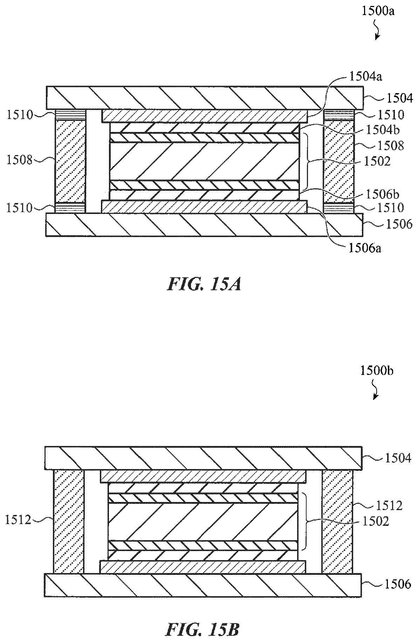

For many embodiments described herein, a piezoelectric component having opposing electrodes, such as the piezoelectric component 1300 depicted in FIGs. 13A - 13B, can be partially or entirely encapsulated or sealed after an electrical connection is established between the opposing electrodes of the piezoelectric component and one or more flexes. Examples of sealed or encapsulated piezoelectric components having opposing electrodes are provided in FIGs. 15A - 15B. Once encapsulated and/or sealed, the piezoelectric component can be referred to as a haptic element, or more specifically, a "sealed haptic element."

FIG. 15A depicts a simplified cross-section of a sealed haptic element 1500a. The sealed haptic element 1500a includes a piezoelectric component 1502 that is electrically connected to a top flex 1504 and a bottom flex 1506. More specifically, a top contact 1504a associated with the top flex 1504 is connected to a top electrode of the piezoelectric component 1502 via a bonding material 1504b. Similarly, a bottom contact 1506a associated with the bottom flex 1506 is connected to a bottom electrode of the piezoelectric component 1502 via a bonding material 1506b.

The top flex 1504 and the bottom flex 1506 each overhang the sidewalls of the piezoelectric component 1502 and are connected via a frame 1508. The amount of overhang varies from embodiment to embodiment but may be selected based on one or more operational parameters of the piezoelectric component 1502. More particularly, the smaller the overhang, the more the top flex 1504, the bottom flex 1506, and the frame 1508 may impact the performance of the piezoelectric component.

In the illustrated embodiment, the frame 1508 is attached to an underside of the top flex 1504 and to a top side of the bottom flex 1506 via an adhesive 1510. The frame 1508 can be made from any number of suitable materials including polymers and elastomers.

In this manner, the frame 1508 and the adhesive 1510 collectively form a seal with the top flex 1504 and the bottom flex 1506 that encloses the piezoelectric component 1502. The various properties of the various components (e.g., the frame 1508, the adhesive 1510, the top flex 1504, the bottom flex 1506, and so on) that cooperate to form the seal may be selected and/or configured to provide thermal, mechanical, electrical, optical, and/or chemical protection to the piezoelectric component 1502.

As illustrated, the seal is separated from sidewalls of the piezoelectric component 1502 by a gap. In some case, the gap between the sidewalls of the piezoelectric component 1502 and the seal can be filled with a gas (e.g., air, nitrogen, helium and so on), a gel (e.g., polymer gel), or liquid (e.g., mineral oil, glycerin). The pressure of the gas, gel, or liquid can vary from embodiment to embodiment. In further cases, the seal formed by the frame 1508 and the adhesive 1510 may abut one or more of the sidewalls of the piezoelectric component 1502.

In some embodiments, the frame 1508 can be formed in another manner. For example, as shown in FIG. 15B, the top flex 1504 and the bottom flex 1506 of a sealed haptic element 1500b can be connected directly by an adhesive ring 1512. In this embodiment, additional adhesive, such as the adhesive 1510 depicted in FIG. 15A, may not be required.

In this manner, similar to other embodiments described herein, the adhesive ring 1512 forms a seal with the top flex 1504 and the bottom flex 1506 that encloses the piezoelectric component 1502. As noted with respect to the embodiment depicted in FIG. 15A, various properties of the various components (e.g., the adhesive ring 1512, the top flex 1504, the bottom flex 1506, and so on) that cooperate to form the seal may be selected and/or configured to provide thermal, mechanical, electrical, optical, and/or chemical protection to the piezoelectric component 1502.

As with the embodiment depicted in FIG. 15A, the seal shown in FIG. 15B is separated from sidewalls of the piezoelectric component 1502 by a gap. The gap between the sidewalls of the piezoelectric component 1502 and the seal can be filled with a gas (e.g., air, nitrogen, helium and so on), a gel (e.g., polymer gel), or liquid (e.g., mineral oil, glycerin). The pressure of the gas, gel, or liquid can vary from embodiment to embodiment. In further cases, the sealed formed by the adhesive ring 1512 may abut one or more of the sidewalls of the piezoelectric component 1502.

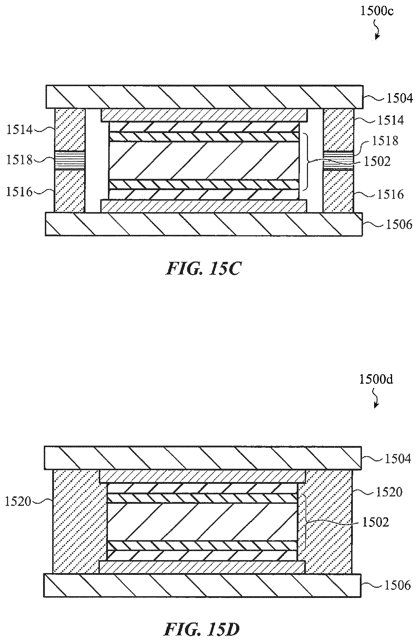

In another embodiment depicted in FIG. 15C, the top flex 1504 and the bottom flex 1506 can be coupled together by aligning complimentary adhesive rings. In particular, a first adhesive ring 1514 can be coupled to an underside of the top flex 1504 and a second adhesive ring 1516 can be coupled to a top side of the bottom flex 1506. The first adhesive ring 1514 can attach directly to the second adhesive ring 1516 or, in some embodiments, a backing adhesive 1518 may be used.

In this manner, similar to other embodiments described above, the first adhesive ring 1514, the second adhesive ring 1516, and the backing adhesive 1518 collectively form a seal with the top flex 1504 and the bottom flex 1506 that encloses the piezoelectric component 1502. The various properties of the various components (e.g., the first adhesive ring 1514, the second adhesive ring 1516, the backing adhesive 1518, the top flex 1504, the bottom flex 1506, and so on) that cooperate to form the seal may be selected and/or configured to provide thermal, mechanical, electrical, optical, and/or chemical protection to the piezoelectric component 1502.

As illustrated, the seal is separated from sidewalls of the piezoelectric component 1502 by a gap. In some cases, the gap between the sidewalls of the piezoelectric component 1502 and the seal can be filled with a gas (e.g., air, nitrogen, helium and so on), a gel (e.g., polymer gel), or liquid (e.g., mineral oil, glycerin). The pressure of the gas, gel, or liquid can vary from embodiment to embodiment. In further cases, the seal formed by the first adhesive ring 1514, the second adhesive ring 1516, the backing adhesive 1518 may abut one or more of the sidewalls of the piezoelectric component 1502.

In a further embodiment depicted in FIG. 15D, a conforming sealant 1520 can be added around the perimeter of piezoelectric component 1502, between the top flex 1504 and the bottom flex 1506. The conforming sealant 1520 can be a polymer-based sealant, an epoxy-based sealant, a poly-silicone based sealant, a resin-based sealant, or any other suitable sealant material or combination of materials. In some embodiments, only one layer of sealant is used. The conforming sealant 1520 can contact sidewalls of the piezoelectric component 1502, such as shown in FIG. 15D, although this may not be required.

The foregoing embodiments depicted in FIGs. 15A - 15D and the various alternatives thereof and variations thereto are presented, generally, for purposes of explanation, and to facilitate a thorough understanding of various possible configurations of a sealed haptic element that includes a piezoelectric component with opposing electrodes. In particular, these embodiments reference a sealed haptic element that encloses a piezoelectric component between a top flex and a bottom flex. However, it will be apparent to one skilled in the art that some of the specific details presented herein may not be required in order to practice a particular described embodiment, or an equivalent thereof.

More specifically, a piezoelectric component with opposing electrodes can be encapsulated with a single flex. In these embodiments, an interposer can be used in place of a wrap-around electrode or a bottom flex. The interposer can establish an electrical connection between the bottom electrode of the piezoelectric component and a second electrical contact of the flex. In these embodiments, the interposer can be encapsulated with the piezoelectric component, thereby sealing the piezoelectric component.

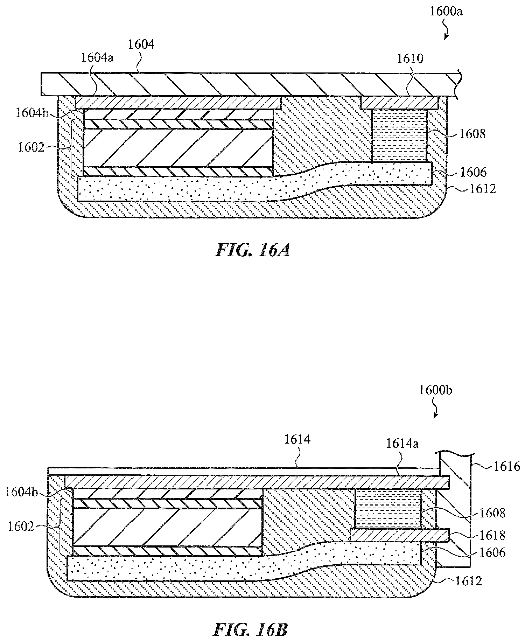

For example, FIG. 16A depicts a simplified cross-section of an encapsulated haptic element incorporating an interposer. The encapsulated haptic element 1600a includes a piezoelectric component 1602 that is electrically connected to a flex 1604. More specifically, a first contact 1604a associated with a first portion of the flex 1604 is connected to a top electrode of the piezoelectric component 1602 via a bonding material 1604b. A bottom electrode of the piezoelectric component 1602 is connected, via an interposer 1606 and a separator 1608, to a second contact 1610 associated with a second portion of the flex 1604. The piezoelectric component 1602, the first contact 1604a, the second contact 1610, the interposer 1606 and the separator 1608 can be encapsulated in an encapsulant 1612. In this embodiment, the flex 1604 is generally parallel to the piezoelectric component 1602.

In many embodiments, the interposer 1606 and the separator 1608 are electrically conductive. In some cases, the separator 1608 may not be required. In other cases, the separator 1608 may be an electrically insulating element. For example, as shown in FIG. 16B, an encapsulated haptic element 1600b uses the separator 1608 to separate a first contact 1614a and a second contact 1618. In this embodiment, a backing material 1614 may be used as a backing for the encapsulant 1612. In this embodiment, a flex 1616 is generally perpendicular to the piezoelectric component 1602.

In these embodiments, the encapsulant 1612 can be formed from any number of suitable materials such as, but not limited to, a polymer-based encapsulant, an epoxy-based encapsulant, a poly-silicone based encapsulant, a resin-based encapsulant, or any other encapsulant material or combination of materials. In some embodiments, only one layer of the encapsulant 1612 is used.

It may be appreciated that the foregoing description of FIGs. 13A - 16B, and various alternatives thereof and variations thereto are presented, generally, for purposes of explanation, and to facilitate a thorough understanding of various possible configurations of a haptic output system as contemplated herein. However, it will be apparent to one skilled in the art that some of the specific details presented herein may not be required in order to practice a particular described embodiment, or an equivalent thereof.

In particular, it may be appreciated that the haptic elements described above can be assembled and/or manufactured in any number of suitable ways. For example, in many cases, the piezoelectric component 1502 depicted in FIGs. 15A - 15D can be electrically connected to the top flex and bottom flex (via the top and bottom contacts and bonding material) in a single lamination operation, although this is not required and multiple lamination operations or other operations can be performed.

The single lamination operation may be performed at a particular temperature or pressure. In one example, the lamination operation can be performed at or above a cross-linking temperature of the bonding material. In these examples, the seal (e.g., the frame 1508, the adhesive ring 1512, the first and second adhesive rings 1514, 1516, and so on) can be partially or completely formed in the same lamination operation. In other cases, the seal can be formed after the electrical connection is established between the piezoelectric component and the top and bottom flexes.

In some cases, a particular embodiment may be selected based, at least in part, on a cross-linking temperature and/or bonding temperature or pressure of the bonding material. For example, for higher cross-linking/bonding temperatures or pressures, the embodiment depicted in FIG. 15C may be chosen; the backing adhesive 1518 may provide a reliable mechanical seal between the first and second adhesive rings 1514, 1516. For lower cross-linking/bonding temperatures or pressures, the embodiment depicted in FIG. 15A or 15B may be chosen.

Thus, the foregoing and following descriptions and specific embodiments are understood to be presented for the limited purposes of illustration and description. These descriptions are not targeted to be exhaustive or to limit the disclosure to the precise forms recited herein. To the contrary, it will be apparent to one of ordinary skill in the art that many modifications and variations are possible in view of the above teachings.

The piezoeletric component of the invention includes a wrap-around electrode. FIGs. 17A - 17G reference methods and/or techniques of encapsulating a piezoelectric component with a wrap-around electrode. It will be appreciated, however, that the depicted examples are not exhaustive; the various embodiments depicted and described with reference to FIGs. 17A - 17G may be modified or combined in any number of suitable or implementation-specific ways to encapsulate, seal, pot, cast, or otherwise encase a piezoelectric component having a wrap-around electrode. In many cases, encapsulation of the piezoelectric component provides protection from, without limitation, metal corrosion, oxidation, contamination, scratching, or shattering.

FIG. 17A depicts a simplified cross-section of a piezoelectric component 1700 of a haptic element, such as the haptic element 1208 depicted in FIG. 12B. As with the piezoelectric component 1300 depicted in FIG. 13A, the piezoelectric component 1700 includes a sheet of piezoelectric material, labeled as the sheet 1702, and two electrodes defined on opposite faces of the sheet 1702. For example, a first electrode 1704 can be formed on a top face of the sheet 1702 and a second electrode 1706 can be formed on a bottom face of the sheet 1702. In this embodiment, the second electrode 1706 wraps around a sidewall of the sheet 1702 and terminates on the top face of the sheet 1702. In this manner, the second electrode 1706 is a wrap-around electrode. The first electrode 1704 and the second electrode 1706 are separated by a gap 1708.

The first electrode 1704 and the second electrode 1706 can be formed in any number of suitable ways. In one embodiment, the first electrode 1704 and the second electrode 1706 are thin-film layers formed by sputtering, physical vapor deposition, printing, or any other suitable technique. The first electrode 1704 and the second electrode 1706 are typically formed from metal or a metal alloy such as silver, silver ink, copper, copper-nickel alloy, and so on. In other embodiments, other conductive materials can be used.

In some embodiments, the piezoelectric component 1700 takes a different shape than that depicted. For example, as with the piezoelectric component 1300 depicted in FIG. 13A, the piezoelectric component 1700 may be 3cm in width and may be approximately 100µm thick. In other cases, other sizes or shapes may be appropriate.

In some cases, the second electrode 1706 can be formed by defining the gap 1708. More particularly, a single electrode, wrapping over three or more faces of the sheet 1702 can be etched, routed, or otherwise divided using a suitable method into two electrodes on a single face of the sheet. In other cases, the gap 1708 may be defined by a mask applied to the sheet 1702 prior to forming the first electrode 1704 and the second electrode 1706.

In still further embodiments, a piezoelectric component 1700 can include more than one wrap-around electrode, such as shown in FIG. 17B. In some cases, a piezoelectric component 1700 with more than one wrap-around electrode may be used to decrease manufacturing complexity by increasing symmetry of the piezoelectric component 1700.

FIG. 17C depicts the piezoelectric component 1700 of FIG. 17A electrically coupled to a flex and encapsulated. In particular, the first electrode 1704 forms a first electrical connection with a flex 1710. More specifically an anisotropic sheet 1712 is positioned between the first electrode 1704 and a first contact 1714 that extends from an underside of the flex 1710. In this manner, the anisotropic sheet 1712 establishes an electrical connection between the first electrode 1704 and the first contact 1714.

In many embodiments, the anisotropic sheet 1712 also extends between the second electrode 1706 and a second contact 1716 that extends from an underside of the flex 1710. In this manner, the anisotropic sheet 1712 establishes an electrical connection between the second electrode 1706 and the second contact 1716.

The anisotropic sheet 1712 is configured to conduct electric current in one direction, but not in another direction. More specifically, the anisotropic sheet 1712 conducts electrical current between the first contact 1714 and the first electrode 1704, but due to an anisotropic property of the anisotropic sheet 1712, it does not conduct electricity between the first electrode 1704 and the second electrode 1706. Similarly, the anisotropic sheet 1712 conducts electrical current between the second contact 1716 and the second electrode 1706, but due to the anisotropic property of the anisotropic sheet 1712, it does not conduct electricity between the second electrode 1706 and the first electrode 1704.

In other embodiments the anisotropic sheet 1712 may include one or more conductive portions and one or more non-conductive portions. The conductive portions can be positioned relative to the first contact 1714 and the first electrode 1704 and the second contact 1716 and the second electrode 1706. In this example, the non-conductive portion can be positioned between the first contact 1714 and the second contact 1716. Such a configuration is illustrated in FIG. 17D, particularly showing a non-conductive portion 1712a of the anisotropic sheet 1712 positioned between a first conductive portion 1712b and a second conductive portion 1712c. In some cases, the non-conductive portion 1712a can be formed with the anisotropic sheet 1712, whereas in other cases the non-conductive portion 1712a is formed from a different material. In still further cases, the non-conductive portion 1712a may not be required; the anisotropic sheet 1712 can extend between the first contact 1714 and the second contact 1716. Such a configuration is illustrated in FIG. 17E.

The flex 1710 as shown in FIG. 17C can be made from any number of suitable materials including flexible circuit board material. In many cases the flex 1710 can be sized to overhang sidewalls of the piezoelectric component 1700, although this may not be required. In many cases, the flex 1710 can electrically couple the piezoelectric component 1700 to a control circuit (not shown), or to another piezoelectric component in a master/slave configuration.

The first contact 1714 and the second contact 1716 are typically formed from copper or silver, although this may not be required and other metals or electrically conductive materials may be used. In many cases, the first contact 1714 is connected to the first electrode 1704 in the same operation that connects the second contact 1716 to the second electrode 1706.

The anisotropic sheet 1712 can be formed from any suitable electrically conductive material or combination of anisotropic materials such as, but not limited to: directionally conductive adhesive, directionally conductive tape, collimated conductors, and so on. In other cases, the anisotropic sheet 1712 may be a non-conductive sheet. In these examples, the piezoelectric component 1700 can be driven capacitively. In other cases, non-conductive bonding material can be used to hold the first electrode 1704 in contact with the first contact 1714 and, similarly, the second electrode 1706 in contact with the second contact 1716.

It may be appreciated that the thickness and/or placement of the anisotropic sheet 1712 may vary from embodiment to embodiment; the illustrated proportions of the anisotropic sheet 1712 are not required. Further, it may be appreciated that the anisotropic sheet 1712 may be disposed at another location or may be disposed to overflow beyond the faces of the piezoelectric component 1700. Accordingly, it is understood that the anisotropic sheet 1712 as depicted in FIG. 17C broadly represents an electrical and/or mechanical element or layer (or combination of elements or layers) that establishes and/or maintains an electrical connection between two electrodes of a piezoelectric component with two corresponding electrical contact of a flex or other circuit.

The piezoelectric component 1700, the first electrode 1704, the first contact 1714, the second electrode 1706, the second contact 1716, and the anisotropic sheet 1712 are encapsulated in an encapsulant 1718. In this embodiment, the flex 1710 is generally parallel to the piezoelectric component 1602. In these embodiments, the encapsulant 1718 can be formed from any number of suitable materials such as, but not limited to a polymer-based encapsulant, an epoxy-based encapsulant, a poly-silicone based encapsulant, a resin-based encapsulant, or any other encapsulant material or combination of materials. In some embodiments, only one layer of the encapsulant 1718 is used. The encapsulant 1718 can be optically transparent or optically opaque.

In other cases, a piezoelectric component having a wrap-around electrode can be formed in another manner. For example, FIG. 17F depicts a simplified cross-section of another haptic element incorporating a piezoelectric component such as shown in FIG. 17A. In this example, the piezoelectric component 1700 can be encapsulated prior to attaching the encapsulated component to the flex and prior to establishing electrical connections between the first electrode and the first contact and the second electrode and the second contact.

In particular, the piezoelectric component 1700 can be encapsulated by an encapsulant 1718. Two electrically conductive inserts can be positioned in electrical contact with one of the first electrode 1704 and the second electrode 1706. For example, a first electrically-conductive insert 1720 can be positioned in electrical contact with the first electrode 1704 and a second electrically-conductive insert 1722 can be positioned in electrical contact with the second electrode 1706.

The first electrically-conductive insert 1720 and the second electrically-conductive insert 1722 can be formed from any number of electrically conductive materials and may be positioned within the encapsulant 1718 in any suitable manner. For example, the first electrically-conductive insert 1720 and the second electrically-conductive insert 1722 can be electrically coupled to the first and second electrodes respectively prior to application of the encapsulant 1718. In another example, the piezoelectric component 1700 can be fully encapsulated with the encapsulant 1718, after which channels through the encapsulant 1718 can be etched, routed, or otherwise defined. The first electrically-conductive insert 1720 and the second electrically-conductive insert 1722 can be thereafter inserted into these channels. In yet another embodiment, the first electrically-conductive insert 1720 and the second electrically-conductive insert 1722 can be inserted into the encapsulant 1718 prior to curing of the encapsulant 1718.

It may be appreciated that the example techniques for establishing an electrical connection between the first electrically-conductive insert 1720 and the first electrode 1704 and the second electrically-conductive insert 1722 and the second electrode 1706 presented above are merely examples; any number of suitable techniques can be used.

In this embodiment, similar to the embodiment depicted in FIG. 17C, an anisotropic sheet 1712 can be positioned between the first electrically-conductive insert 1720 and a first contact 1714 that extends from an underside of the flex 1710. In this manner, the anisotropic sheet 1712 and the first electrically-conductive insert 1720 cooperate to establish an electrical connection between the first electrode 1704 and the first contact 1714.

In many embodiments, the anisotropic sheet 1712 also extends between the second electrically-conductive insert 1722 and a second contact 1716 that extends from an underside of the flex 1710. In this manner, the anisotropic sheet 1712 and the second electrically-conductive insert 1722 cooperate to establish an electrical connection between the second electrode 1706 and the second contact 1716.

As with other embodiments described herein, the anisotropic sheet 1712 can be configured to conduct electric current in one direction, but not in another direction. More specifically, the anisotropic sheet 1712 conducts electrical current between the first contact 1714 and the first electrically-conductive insert 1720, but due to an anisotropic property of the anisotropic sheet 1712, it does not conduct electricity between the first electrically-conductive insert 1720 and the second electrically-conductive insert 1722. Similarly, the anisotropic sheet 1712 conducts electrical current between the second contact 1716 and the second electrically-conductive insert 1722, but due to the anisotropic property of the anisotropic sheet 1712, it does not conduct electricity between the second electrically-conductive insert 1722 and the first electrically-conductive insert 1720.

In this embodiment, as with others described herein, the flex 1710 can be made from any number of suitable materials including a flexible circuit board material. In many cases the flex 1710 is sized to overhang sidewalls of the piezoelectric component 1700, although this may not be required. For example, the flex may be smaller than the encapsulated piezoelectric component 1700. In many cases, the flex 1710 can electrically couple the piezoelectric component 1700 to a control circuit (not shown), or to another piezoelectric component in a master/slave configuration.

As with the embodiment depicted in FIG. 17C, the first contact 1714 and the second contact 1716 are typically formed from an electrically conductive material such as copper or silver, although this may not be required and other metals or electrically conductive materials may be used. In many cases, the first contact 1714 is connected to the first electrically-conductive insert 1720 in the same operation that connects the second contact 1716 to the second electrically-conductive insert 1722.

The anisotropic sheet 1712 can be formed from any suitable electrically conductive material or combination of anisotropic materials such as, but not limited to: directionally conductive adhesive, directionally conductive tape, collimated conductors, and so on. In other cases, the anisotropic sheet 1712 may be a non-conductive sheet. In these examples, the piezoelectric component 1700 can be driven capacitively. In other cases, non-conductive bonding material can be used to hold the first electrically-conductive insert 1720 in contact with the first contact 1714 and, similarly, the second electrically-conductive insert 1722 in contact with the second contact 1716.

In other cases, such as depicted in FIG. 17G, the piezoelectric component may be encapsulated and/or sealed against a substrate, such as the substrate 1724. In one embodiment, the substrate 1724 is a backing material used in a roll-to-roll manufacturing process. In some cases, the substrate 1724 is flexible, although this may not be required. For example, the substrate 1724 may serve as a stiffener.

It may be appreciated that the foregoing description of FIGs. 17A - 17G, and various alternatives thereof and variations thereto are presented, generally, for purposes of explanation, and to facilitate a thorough understanding of various possible configurations of a sealed haptic element of a haptic output system as contemplated herein. However, it will be apparent to one skilled in the art that some of the specific details presented herein may not be required in order to practice a particular described embodiment, or an equivalent thereof, provided that the outcoming subject-matter falls under the claims, which solely define the invention.

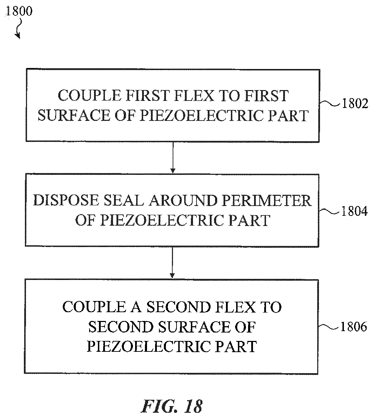

Thus, the foregoing and following descriptions and specific embodiments are understood to be presented for the limited purposes of illustration and description. These descriptions are not targeted to be exhaustive or to limit the disclosure to the precise forms recited herein. To the contrary, it will be apparent to one of ordinary skill in the art that many modifications and variations are possible in view of the above teachings. In particular, a piezoelectric component may be encapsulated and/or sealed using any number of suitable techniques or methods may be used. Certain example methods of sealing or encapsulating a piezoelectric component are described below in reference to FIGs. 18 - 21. The phrase "piezoelectric part" is meant to encompass piezoelectric components having opposing electrodes, a piezoelectric component having a wrap-around electrode, or a piezoelectric component having more than one wrap-around electrode, such as electrodes that wrap from a face of a piezoelectric sheet to a sidewall of the piezoelectric sheet.

FIG. 18 is a simplified flow chart depicting example operations of a method of encapsulating a piezoelectric part. The method 1800 begins at operation 1802 in which a first flex is coupled to a first surface or face of a piezoelectric part. Next, at operation 1804, a seal is disposed around a periphery of the piezoelectric part. In many cases, the seal is disposed on a surface of the first flex, although this is not required. Next, at operation 1806, a second flex is coupled to a second surface or face of the piezoelectric part. As a result, the piezoelectric part is enclosed and protected by the first flex, the second flex, and the periphery seal.

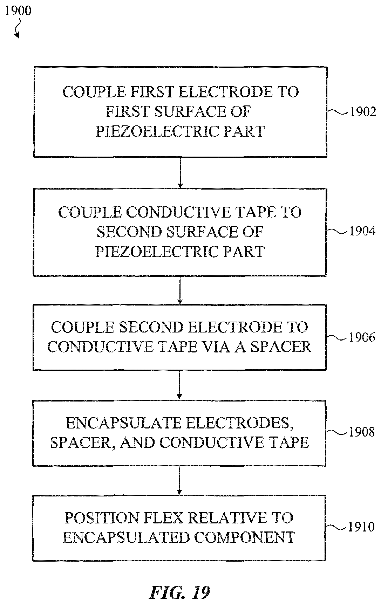

FIG. 19 is a simplified flow chart depicting example operations of another method of encapsulating a piezoelectric part. The method 1900 begins at operation 1902 in which a first electrode or contact is coupled to a first surface or face of a piezoelectric part. Next, at operation 1904, an interposer (or conductive tape) is coupled to a second surface or face of the piezoelectric part. Next, at operation 1906, a second electrode or contact can be coupled to the interposer (or conductive tape) via a spacer. Next, at operation 1908, the electrodes, spacer, and interposer or conductive tape can be encapsulated. Finally, at operation 1910, a flex can be positioned relative to the encapsulated component. The flex can be coupled to the first and second electrode or contact or, in another embodiment, an anisotropic conductive tape can be used to connect the first and second contact to the flex. In some cases, the flex can be laminated to the encapsulated component.

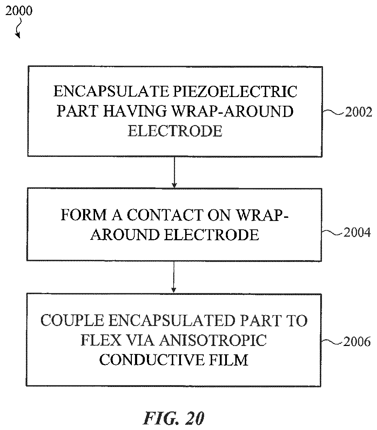

FIG. 20 is a simplified flow chart depicting example operations of another method of a piezoelectric part. The method 2000 can begin at operation 2002 in which a piezoelectric part having a wrap-around electrode is encapsulated. Next at operation 2004, an electrical connection can be established with the wrap-around electrode. In many cases, the electrical connection can be made between the wrap-around electrode and an electrically conductive insert that extends through the encapsulation material. Next, at operation 2006, the encapsulated part is coupled to a flex via an anisotropic conductive film.

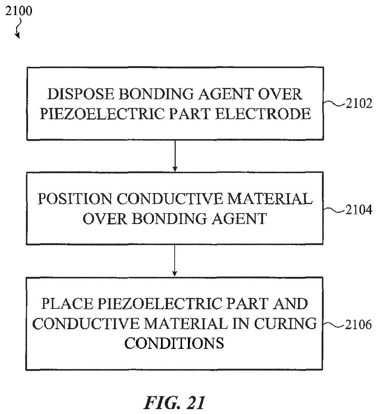

FIG. 21 is a simplified flow chart depicting example operations of another method of a piezoelectric part. The method 2100 begins at operation 2102 in which a bonding agent or bonding material is disposed over an electrode of a piezoelectric part. Next, at operation 2104, a conductive material is positioned over the bonding agent. The conductive material may be an electrical contact of a flexible circuit. Next, at operation 2106, the piezoelectric part and conductive material can be placed into conditions suitable for curing the bonding agent. Suitable curing conditions can include exposure to, without limitation, ultraviolet light, increased temperature, increased pressure, vibrations, and so on.

One may appreciate that although many embodiments are disclosed above, that the operations and steps presented with respect to methods and techniques described herein are meant as exemplary and accordingly are not exhaustive. One may further appreciate that alternate step order or, fewer or additional operations may be required or desired for particular embodiments.

Although the disclosure above is described in terms of various exemplary embodiments and implementations, it should be understood that the various features, aspects and functionality described in one or more of the individual embodiments are not limited in their applicability to the particular embodiment with which they are described, but instead can be applied, alone or in various combinations, to one or more of the same embodiments of the invention, whether or not such embodiments are described and whether or not such features are presented as being a part of a described embodiment. Thus, the breadth and scope of the present invention should not be limited by any of the above-described exemplary embodiments but is instead defined by the claims herein presented.

As described above and illustrated in the accompanying figures, the present disclosure relates to localized and/or encapsulated haptic actuators or elements. More particularly, embodiments discussed within relate to haptic actuators that include electrode patterning for generating localized haptic output and/or encapsulated elements of a haptic output system. In localized haptic actuator embodiments, a haptic actuator includes piezoelectric material and a patterned electrode. The patterned electrode can apply voltage to different portions of the piezoelectric material. This allows localized haptic output as the location where a maximum deflection is produced in the piezoelectric material depends on the voltages applied. In haptic output system encapsulated element embodiments, one or more fragile or sensitive components of a haptic output system that may be included in an electronic device may be packaged, sealed, and/or encapsulated.

In the present disclosure, the methods disclosed may be implemented as sets of instructions or software readable by a device. Further, it is understood that the specific order or hierarchy of steps in the methods disclosed are examples of sample approaches. In other embodiments, the specific order or hierarchy of steps in the method can be rearranged while remaining within the disclosed subject matter. The accompanying method claims present elements of the various steps in a sample order, and are not necessarily meant to be limited to the specific order or hierarchy presented.

The foregoing description, for purposes of explanation, used specific nomenclature to provide a thorough understanding of the described embodiments. However, it will be apparent to one skilled in the art that the specific details are not required in order to practice the described embodiments. Thus, the foregoing descriptions of the specific embodiments described herein are presented for purposes of illustration and description. They are not targeted to be exhaustive or to limit the embodiments to the precise forms disclosed. It will be apparent to one of ordinary skill in the art that many modifications and variations are possible in view of the above teachings, provided the fall under the scope of the claims, which solely define the invention.

## Claims

1. A haptic element (1208) comprising:
a piezoelectric component (1700) comprising:
a piezoelectric sheet (1702);
a first electrode (1704) formed on a first face of the sheet (1702); and
a second electrode (1706) having a first portion formed on a second face of the sheet (1702) and having a second portion formed on the first face of the sheet (1702);
a flex (1710) comprising a first contact (1714) and a second contact (1716), the flex (1710) positioned relative to the first face such that the first electrode (1704) and the first contact (1714) are electrically connected and the second electrode (1706) and the second contact (1716) are electrically connected;
an anisotropic film (1712) bonding the first contact portion (1714) to the first electrode (1704) and connected to the second electrode (1706); and
an encapsulation layer (1718) disposed over the piezoelectric component (1700) thereby enclosing the piezoelectric component (1700) against the flex (1710).

2. The haptic element (1208) of claim 1, wherein the anisotropic film (1712) is positioned between the first contact (1714) and the first electrode (1704).

3. The haptic element (1208) of claim 2, wherein the anisotropic film (1712) extends between the second contact (1716) and the second electrode (1706).

4. The haptic element (1208) of claim 1, wherein the anisotropic film (1712) is anisotropically conductive;

5. The haptic element (1208) of claim 1, wherein the anisotropic film is (1712) is non-conductive.

6. The haptic element (1208) of claim 5, wherein the piezoelectric component is capacitively driven.

7. The haptic element (1208) of claim 1, wherein the first face opposes the second face.

8. The haptic element (1208) of claim 1, wherein:
the sheet (1702) includes a third face adjacent to the first face of the sheet (1702) and the second face of the sheet (1702); and
the second electrode (1706) has a third portion between the first portion and the second portion that is formed on the third face.

9. The haptic element (1208) of claim 1, wherein the first electrode (1704) extends around the piezoelectric sheet (1702) from the first face of the sheet (1702) to the second face of the sheet (1702).

10. The haptic element (1208) of claim 9, wherein the first electrode (1704) and the second electrode (1706) define a gap (1708) between them on the second face of the sheet (1702).

11. The haptic element (1208) of claim 1, wherein the first electrode (1704) and the second electrode (1706) define a gap (1708) between them on the first face of the sheet (1702).

12. The haptic element (1208) of claim 1, wherein:
the sheet (1702) includes a third face adjacent to the first face of the sheet (1702) and the second face of the sheet (1702); and
the first electrode (1704) and the second electrode (1706) are absent from the third face.

13. The haptic element (1208) of claim 1, wherein the flex (1710) is positioned parallel to the first face of the sheet (1702).

14. The haptic element (1208) of claim 1, wherein the first contact (1714) and the second contact (1716) are positioned parallel to the first face of the sheet (1702).

15. A haptic output system comprising:
an input surface (1206); and
an array of the haptic element of claim 1 subjacent the input surface (1206).

16. The haptic output system of claim 15, wherein a portion of the encapsulation layer (1718) of at least one haptic element (1208) of the array of haptic elements is between the flex (1710) and the piezoelectric component (1700).

17. The haptic output system of claim 15, wherein the encapsulation layer (1718) of at least one haptic element (1208) of the array of haptic elements is formed from a polymer material.

18. The haptic output system of claim 15, further comprising a display (1204) disposed between the input surface (1206) and the array of haptic elements.

19. The haptic output system of claim 15, wherein at least one haptic element (1208) of the array of haptic elements comprises an insert (1720, 1722) electrically connecting the electrode (1706) to the electrical contact (1716).

## Patentansprüche

1. Haptisches Element (1208), umfassend:
eine piezoelektrische Komponente (1700), umfassend:
eine piezoelektrische Platte (1702);
eine erste Elektrode (1704), die auf einer ersten Fläche der Platte (1702) ausgebildet ist; und
eine zweite Elektrode (1706) mit einem ersten Teil, der auf einer zweiten Fläche der Platte (1702) ausgebildet ist, und mit einem zweiten Teil, der auf der ersten Fläche der Platte (1702) ausgebildet ist;
ein Biegeelement (1710), das einen ersten Kontakt (1714) und einen zweiten Kontakt (1716) umfasst, wobei das Biegeelement relativ zu der ersten Fläche so angeordnet ist, dass die erste Elektrode (1704) und der erste Kontakt (1714) elektrisch verbunden sind und die zweite Elektrode (1706) und der zweite Kontakt (1716) elektrisch verbunden sind;
einen anisotropen Film (1712), der den ersten Kontakt (1714) mit der ersten Elektrode (1704) verbindet und mit der zweiten Elektrode (1706) verbunden ist; und
eine Verkapselungsschicht (1718), die über der piezoelektrischen Komponente (1700) angeordnet ist und dadurch die piezoelektrische Komponente (1700) gegen das Biegeelement (1710) einschließt.

2. Haptisches Element (1208) nach Anspruch 1, wobei der anisotrope Film (1712) zwischen dem ersten Kontakt (1714) und der ersten Elektrode (1704) angeordnet ist.

3. Haptisches Element (1208) nach Anspruch 2, wobei sich der anisotrope Film (1712) zwischen dem zweiten Kontakt (1716) und der zweiten Elektrode (1706) erstreckt.

4. Haptisches Element (1208) nach Anspruch 1, wobei der anisotrope Film (1712) anisotrop leitfähig ist.

5. Haptisches Element (1208) nach Anspruch 4, wobei der anisotrope Film (1712) nicht leitend ist.

6. Haptisches Element (1208) nach Anspruch 5, wobei die piezoelektrische Komponente (1700) kapazitiv betrieben wird.

7. Haptisches Element (1208) nach Anspruch 1, wobei die erste Fläche der zweiten Fläche gegenüberliegt.

8. Haptisches Element (1208) nach Anspruch 1, wobei:
der Film (1702) eine dritte Fläche aufweist, die an die erste Fläche des Films (1702) und die zweite Fläche des Films (1702) angrenzt; und
die zweite Elektrode (1706) einen dritten Teil zwischen dem ersten Teil und dem zweiten Teil aufweist, der auf der dritten Fläche ausgebildet ist.

9. Haptisches Element (1208) nach Anspruch 1, wobei sich die erste Elektrode (1704) um die piezoelektrische Platte (1702) von der ersten Fläche der Platte (1702) zur zweiten Fläche der Platte (1702) erstreckt.

10. Haptisches Element (1208) nach Anspruch 9, wobei die erste Elektrode (1704) und die zweite Elektrode (1706) einen Spalt (1708) zwischen sich auf der zweiten Seite der Platte (1702) definieren.

11. Haptisches Element (1208) nach Anspruch 1, wobei die erste Elektrode (1704) und die zweite Elektrode (1706) einen Spalt (1708) zwischen sich auf der ersten Seite der Platte (1702) definieren.

12. Haptisches Element (1208) nach Anspruch 1, wobei:
der Film (1702) eine dritte Fläche aufweist, die an die erste Fläche des Films (1702) und die zweite Fläche des Films (1702) angrenzt; und
die erste Elektrode (1704) und die zweite Elektrode (1706) nicht auf der dritten Fläche vorhanden sind.

13. Haptisches Element (1208) nach Anspruch 1, wobei das Biegeelement (1710) parallel zu der ersten Fläche der Platte (1702) angeordnet ist.

14. Haptisches Element (1208) nach Anspruch 1, wobei der erste Kontakt (1714) und der zweite Kontakt (1716) parallel zu der ersten Fläche der Platte (1702) angeordnet sind.

15. Haptisches Ausgabesystem, das Folgendes umfasst:
eine Eingabefläche (1206); und
eine Anordnung des haptischen Elements nach Anspruch 1, die unter der Eingabefläche (1206) liegt.

16. Haptisches Ausgabesystem nach Anspruch 15, wobei ein Teil der Verkapselungsschicht (1718) mindestens eines haptischen Elements (1208) der Anordnung haptischer Elemente zwischen dem Biegeelement (1710) und der piezoelektrischen Komponente (1700) liegt.

17. Haptisches Ausgabesystem nach Anspruch 15, wobei die Verkapselungsschicht (1718) mindestens eines haptischen Elements (1208) der Anordnung haptischer Elemente aus einem Polymermaterial gebildet ist.

18. Haptisches Ausgabesystem nach Anspruch 15 ferner umfassend eine Anzeige (1204), die zwischen der Eingabefläche (1206) und dem Array haptischer Elemente angeordnet ist.

19. Haptisches Ausgabesystem nach Anspruch 15, wobei mindestens ein haptisches Element (1208) der Anordnung von haptischen Elementen einen Einsatz (1720, 1722) umfasst, der die Elektrode (1706) mit dem elektrischen Kontakt (1716) elektrisch verbindet.

## Revendications

1. Un élément haptique (1208) comprenant :
un composant piézoélectrique (1700) comprenant :
une feuille piézoélectrique (1702) ;
une première électrode (1704) formée sur une première face de la feuille (1702) ; et
une seconde électrode (1706) avec une première partie formée sur une seconde face de la feuille (1702) et avec une seconde partie formée sur la première face de la feuille (1702) ;
un circuit flexible (1710) comprenant un premier contact (1714) et un second contact (1716), le circuit flexible (1710) étant positionné par rapport à la première face de telle manière que la première électrode (1704) et le premier contact (1714) soient électriquement reliés et que la seconde électrode (1706) et le second contact (1716) soient électriquement reliés ;
un film anisotrope (1712) liant la première partie de contact (1714) à la première électrode (1704) et relié à la seconde électrode (1706) ; et
une couche d'encapsulation (1718) disposée au-dessus du composant piézoélectrique (1700) en enfermant ainsi le composant piézoélectrique (1700) contre le circuit flexible (1710).

2. L'élément haptique (1208) de la revendication 1, dans lequel le film anisotrope (1712) est positionné entre le premier contact (1714) et la première électrode (1704).

3. L'élément haptique (1208) de la revendication 2, dans lequel le film anisotrope (1712) s'étend entre le second contact (1716) et la seconde électrode (1706).

4. L'élément haptique (1208) de la revendication 1, dans lequel le film anisotrope (1712) est anisotropiquement conducteur.

5. L'élément haptique (1208) de la revendication 1, dans lequel le film anisotrope (1712) est non conducteur.

6. L'élément haptique (1208) de la revendication 5, dans lequel le composant piézoélectrique est piloté capacitivement.

7. L'élément haptique (1208) de la revendication 1, dans lequel la première face est à l'opposé de la seconde face.

8. L'élément haptique (1208) de la revendication 1, dans lequel :
la feuille (1702) comprend une troisième face adjacente à la première face de la feuille (1702) et à la seconde face de la feuille (1702) ; et
la seconde électrode (1706) possède entre la première partie et la seconde partie une troisième partie qui est formée sur la troisième face.

9. L'élément haptique (1208) de la revendication 1, dans lequel la première électrode (1704) s'étend de la première face de la feuille (1702) à la seconde face de la feuille (1702) autour de la feuille piézoélectrique (1702) .

10. L'élément haptique (1208) de la revendication 9, dans lequel la première électrode (1704) et la seconde électrode (1706) définissent entre elles un intervalle (1708) sur la seconde face de la feuille (1702).

11. L'élément haptique (1208) de la revendication 1, dans lequel la première électrode (1704) et la seconde électrode (1706) définissent entre elles un intervalle (1708) sur la première face de la feuille (1702).

12. L'élément haptique (1208) de la revendication 1, dans lequel :
la feuille (1702) comprend une troisième face adjacente à la première face de la feuille (1702) et à la seconde face de la feuille (1702) ; et
la première électrode (1704) et la seconde électrode (1706) sont absentes de la troisième face.

13. L'élément haptique (1208) de la revendication 1, dans lequel le circuit flexible (1710) est positionné parallèle à la première face de la feuille (1702).

14. L'élément haptique (1208) de la revendication 1, dans lequel le premier contact (1714) et le second contact (1716) sont positionnés parallèles à la première face de la feuille (1702).

15. Un système de sortie haptique, comprenant :
une surface d'entrée (1206) ; et
un réseau d'éléments haptiques de la revendication 1, sous-jacent à la surface d'entrée (1206).

16. Le système de sortie haptique de la revendication 15, dans lequel une partie de la couche d'encapsulation (1718) d'au moins un élément haptique (1208) du réseau d'éléments haptiques est entre le circuit flexible (1710) et le composant piézoélectrique (1700) .

17. Le système de sortie haptique de la revendication 15, dans lequel la couche d'encapsulation (1718) d'au moins un élément haptique (1208) du réseau d'éléments haptiques est formée d'un matériau polymère.

18. Le système de sortie haptique de la revendication 15, comprenant en outre un afficheur (1204) disposé entre la surface d'entrée (1206) et le réseau d'éléments haptiques.

19. Le système de sortie haptique de la revendication 15, dans lequel au moins un élément haptique (1208) du réseau d'éléments haptiques comprend un insert (1720, 1722) reliant électriquement l'électrode (1706) au contact électrique (1716).
